# EUROPEAN PATENT APPLICATION

(11) **EP 4 658 021 A1**
(43) Date of publication of application: **03.12.2025**
(21) Application number: 25155674.2
(22) Date of filing: 03.02.2025
(51) Int. Cl.: H10D 84/01, H01L 23/485, H10D 30/00, H10D 64/23, H10D 84/83, H10D 62/17

(54) **SEMICONDUCTOR DEVICE INCLUDING SEPARATION STRUCTURE**

(30) Priority: 28.05.2024 KR 20240069420
(71) Applicant: Samsung Electronics Co., Ltd., Suwon-si, Gyeonggi-do 16677 (KR)
(72) Inventor: CHAE, Myeonggyoon, 16677 Suwon-si (KR); LEE, Kyoungwoo, 16677 Suwon-si (KR); HA, Seungseok, 16677 Suwon-si (KR); KIM, Beomjin, 16677 Suwon-si (KR); KIM, Youngwoo, 16677 Suwon-si (KR); KIM, Junsoo, 16677 Suwon-si (KR); LEE, Minseung, 16677 Suwon-si (KR); CHOI, Shinkyu, 16677 Suwon-si (KR)
(74) Representative: Marks & Clerk LLP

(57) **Abstract**

A semiconductor device includes: a substrate; source/drain patterns on the substrate; a channel pattern between the source/drain patterns, the channel pattern including a plurality of semiconductor patterns; a gate electrode between the plurality of semiconductor patterns; an upper separation structure extending in a first direction and spaced apart from the gate electrode in a second direction intersecting the first direction; a first backside separation structure penetrating the substrate below the gate electrode in a third direction intersecting the first direction and the second direction; and a second backside separation structure penetrating the substrate and overlapping the upper separation structure in the third direction.

## Description

### BACKGROUND

The disclosure relates to a semiconductor device, and more particularly, relates to a semiconductor device including a field effect transistor.

A semiconductor device may include an integrated circuit having, for example, metal-oxide-semiconductor field effect transistors (MOSFET). As the size the semiconductor device continue to become smaller, MOSFETs are increasingly being scaled down. The scale-down of the MOSFET may cause characteristics of certain semiconductor devices to be degraded. Accordingly, various researches have been conducted to overcome the limitations resulting from high integration of the semiconductor device and to manufacture the semiconductor device with high performance.

### SUMMARY

Various embodiments of the disclosure provide a semiconductor device with improved productivity and reliability and a method of manufacturing the same.

The problems to be solved by the disclosure is not limited to the problems mentioned above, and other problems not mentioned will be clearly understood by those skilled in the art from the description below.

According to one or more embodiments, there is provided a semiconductor device which includes: a substrate; source/drain patterns on the substrate; a channel pattern between the source/drain patterns, the channel pattern including a plurality of semiconductor patterns; a gate electrode between the plurality of semiconductor patterns; an upper separation structure extending in a first direction and spaced apart from the gate electrode in a second direction intersecting the first direction; a first backside separation structure penetrating the substrate below the gate electrode in a third direction intersecting the first direction and the second direction; and a second backside separation structure penetrating the substrate and overlapping the upper separation structure in the third direction.

According to one or more embodiments, there is provided a semiconductor device which includes: a substrate; source/drain patterns on the substrate; a channel pattern between the source/drain patterns, the channel pattern including a plurality of semiconductor patterns; a gate electrode between the plurality of semiconductor patterns; an upper separation structure spaced apart from the gate electrode; a first backside separation structure penetrating the substrate below the gate electrode; and a second backside separation structure penetrating the substrate and overlapping the upper separation structure, wherein bottom surfaces of the first and second backside separation structures are positioned at a level than a bottom surface of the substrate.

According to one or more embodiments, there is provided a semiconductor device which may include: a substrate including an active pattern; a device isolation layer on the substrate to define the active pattern; a channel pattern and source/drain patterns on the active pattern; a gate electrode on the channel pattern; a gate insulating layer interposed between the gate electrode and the channel pattern; an upper separation structure spaced apart from the gate electrode and extending in a first direction; an interlayer insulating layer on the source/drain patterns; an upper active contact penetrating the interlayer insulating layer and connected to one of the source/drain patterns; a gate contact connected to the gate electrode; a power transmission network layer below the substrate; a backside active contact penetrating the substrate and connecting the power transmission network layer to the other one of the source/drain patterns; a first backside separation structure penetrating the substrate below the gate electrode; and a second backside separation structure penetrating the substrate and overlapping the upper separation structure, wherein the first backside separation structure and the second backside separation structure each extend in the first direction.

At least some of the above and other features of the invention are set out in the claims

### BRIEF DESCRIPTION OF DRAWINGS

Example embodiments will be more clearly understood from the following brief description taken in conjunction with the accompanying drawings. The accompanying drawings represent non-limiting, example embodiments as described herein.
FIGS. 1 to 3 are conceptual diagrams for explaining logic cells of a semiconductor device, according to one or more embodiments.
FIG. 4 is a plan view for explaining a semiconductor device, according to one or more embodiments.
FIGS. 5A to 5D are cross-sectional views taken along lines A-A', B-B', C-C', and D-D' of FIG. 4A, respectively.
FIG. 6 is an enlarged view showing portion 'P' of FIG. 5A.
FIGS. 7A to 17D are diagrams showing a method of manufacturing a semiconductor device, according to one or more embodiments.

### DETAILED DESCRIPTION

The embodiments described herein are non-limiting example embodiments, and thus, the disclosure is not limited thereto and may be realized in various other forms. As used herein, an expression "at least one of' preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c.

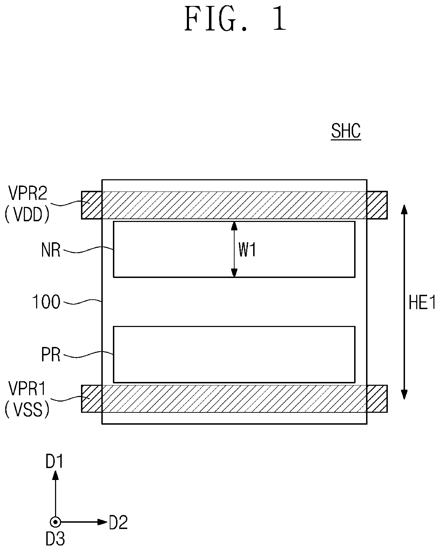

FIGS. 1 to 3 are conceptual plan views of logic cells of a semiconductor device, according to one or more embodiments.

Referring to FIG. 1, a single height cell SHC may be provided, in which a first lower power line VPR1 and a second lower power line VPR2 are provided on a lower portion of a substrate 100. The first lower power line VPR1 may be a path through which a source voltage VSS, for example, a ground voltage, is provided. The second lower power line VPR2 may be a path through which a drain voltage VDD, for example, a power voltage, is provided.

The single height cell SHC may be defined between the first lower power line VPR1 and the second lower power line VPR2. The single height cell SHC may include one p-type MOSFET (PMOSFET) region PR and one n-type MOSFET (NMOSFET) region NR. For example, the single height cell SHC may have a CMOS structure provided between the first lower power line VPR1 and the second lower power line VPR2.

Each of the PMOSFET region PR and the NMOSFET region NR may have a first width W1 in a first direction D 1. A length of the single height cell SHC in the first direction D1 may be defined as a first height HE1. The first height HE1 may be substantially equal to a distance (e.g., pitch) between the first lower power line VPR1 and the second lower power line VPR2.

The single height cell SHC may constitute one logic cell. In this specification, a logic cell may refer to a logic element, a logic circuit, or a logic gate (e.g., AND, OR, XOR, XNOR, inverter, etc.) that performs a corresponding logic function. A logic cell may include transistors for configuring a logic element and wirings connecting the transistors to each other or another circuit element of a semiconductor device.

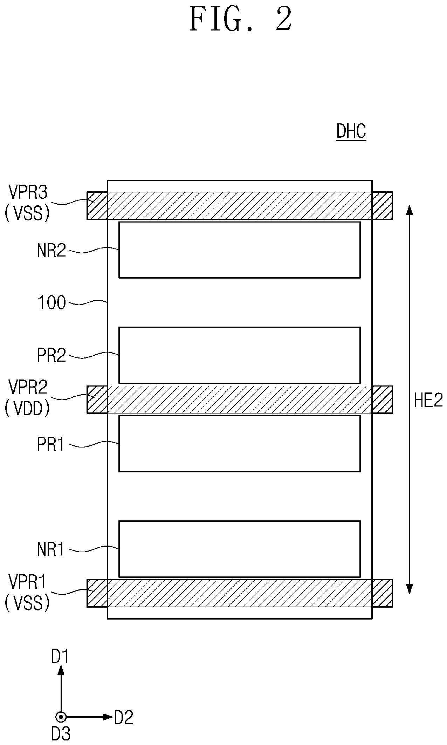

Referring to FIG. 2, a double height cell DHC may be provided, in which a first lower power line VPR1, a second lower power line VPR2, and a third lower power line VPR3 are provided on the substrate 100. The second lower power line VPR2 may be disposed between the first lower power line VPR1 and the third lower power line VPR3. The third lower power line VPR3 may be a path through which a source voltage VSS is provided.

The double height cell DHC may be defined between the first lower power line VPR1 and the third lower power line VPR3. The double height cell DHC may include a first PMOSFET region PR1, a second PMOSFET region PR2, a first NMOSFET region NR1, and a second NMOSFET region NR2.

The first NMOSFET region NR1 may be adjacent to the first lower power line VPR1. The second NMOSFET region NR2 may be adjacent to the third lower power line VPR3. The first and second PMOSFET regions PR1 and PR2 may be adjacent to the second lower power line VPR2. The second lower power line VPR2 may be disposed between the first and second PMOSFET regions PR1 and PR2.

A length of the double height cell DHC in the first direction D1 may be defined as a second height HE2. The second height HE2 may be approximately twice the first height HE1 of FIG. 1. The first and second PMOSFET regions PR1 and PR2 of the double height cell DHC may be bundled to operate as one PMOSFET region. Accordingly, a channel size of the PMOS transistor of the double height cell DHC may be larger than a channel size of the PMOS transistor of the single height cell SHC of FIG. 1.

For example, the channel size of the PMOS transistor of a double height cell DHC may be approximately twice that of the PMOS transistor of a single height cell SHC. As a result, the double height cell DHC may operate at a higher speed compared to the single height cell SHC. The double height cell DHC shown in FIG. 2 may be referred to as an example of a multi-height cell. Examples of a multi-height cell may include a triple-height cell of which a cell height is approximately three times that of a single-height cell SHC.

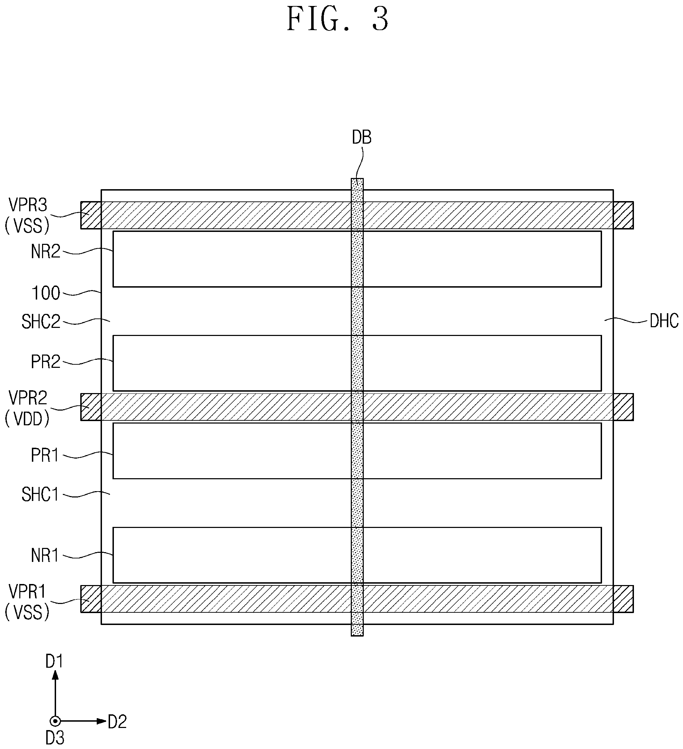

Referring to FIG. 3, a first single height cell SHC1, a second single height cell SHC2, and a double height cell DHC may be two-dimensionally arranged on the substrate 100. The first single height cell SHC1 may be disposed between the first and second lower power lines VPR1 and VPR2. The second single height cell SHC2 may be disposed between the second and third lower power lines VPR2 and VPR3. The second single height cell SHC2 may be adjacent to the first single height cell SHC1 in the first direction D1.

The double height cell DHC may be disposed between the first and third lower power lines VPR1 and VPR3. The double height cell DHC may be adjacent to the first and second single height cells SHC1 and SHC2 in a second direction D2 intersecting the first direction D1.

An upper separation structure DB may be provided between the first single height cell SHC1 and the double height cell DHC, and between the second single height cell SHC2 and the double height cell DHC. An active region of the double height cell DHC may be electrically separated from active regions of each of the first and second single height cells SHC1 and SHC by the upper separation structure DB.

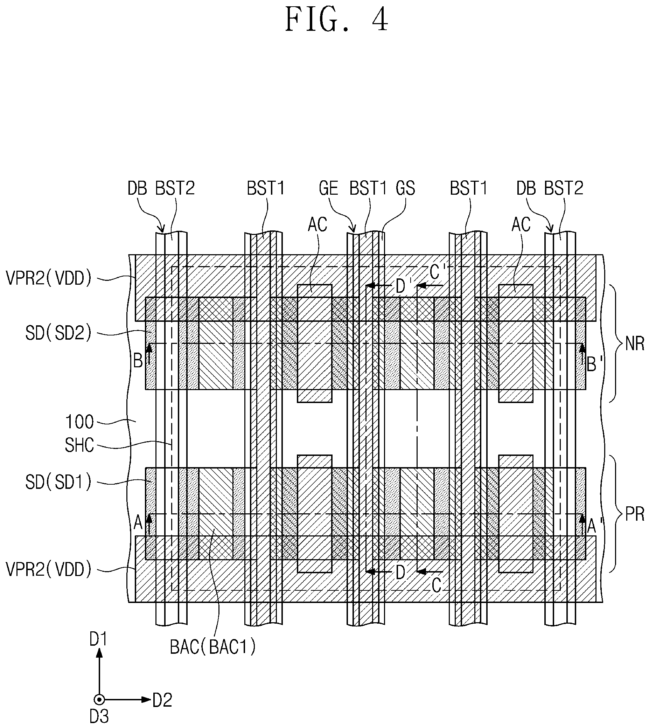

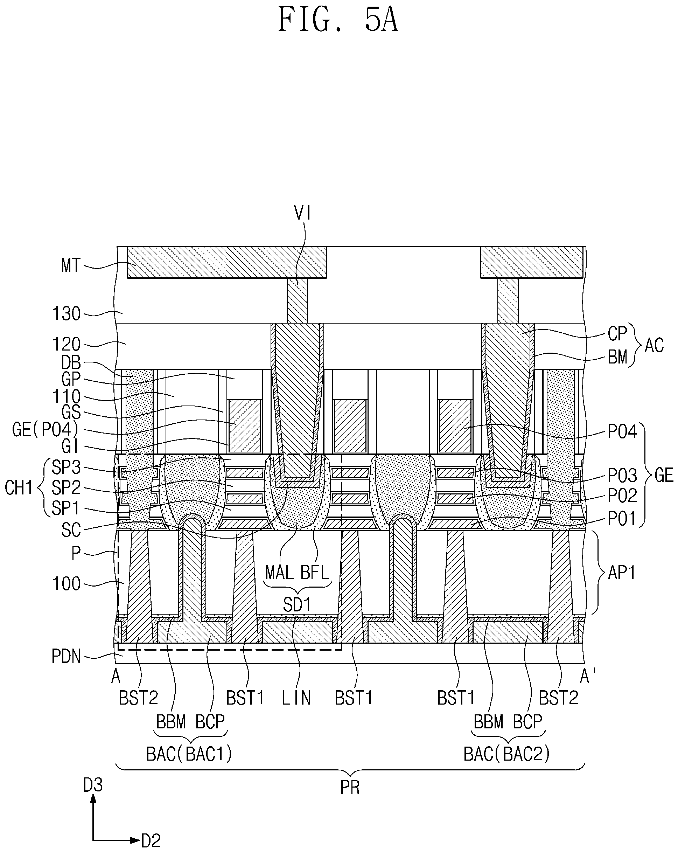

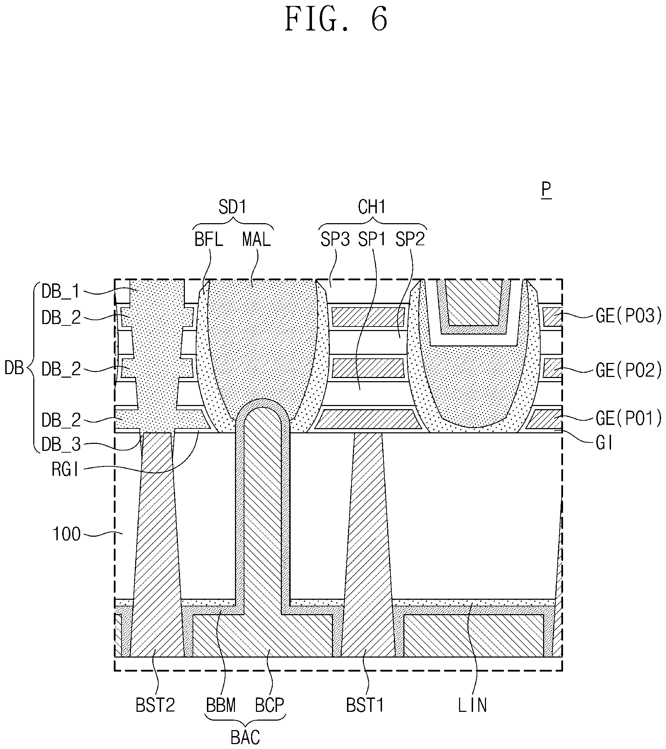

FIG. 4 is a plan view for explaining a semiconductor device, according to one or more embodiments. FIGS. 5A to 5D are cross-sectional views taken along lines A-A', B-B', C-C', and D-D' of FIG. 4A, respectively. FIG. 6 is an enlarged view showing portion 'P' of FIG. 5A.

Referring to FIGS. 4 and 5A to 5D, a single height cell SHC may be provided on a substrate 100. For example, the single height cell SHC may be the single height cell SHC described above in FIG. 1 or one of the first and second single height cells SHC1 and SHC2 described above in FIG. 3. Transistors constituting a logic circuit may be disposed on single height cells SHC. As an example, the substrate 100 may be a semiconductor substrate including silicon, germanium, silicon-germanium, etc., a compound semiconductor substrate, or a silicon substrate. As another example, the substrate 100 may be or include a silicon-based insulating layer formed of silicon oxide, silicon nitride, and or silicon oxynitride.

The substrate 100 may have a PMOSFET region PR and a NMOSFET region NR. Each of the PMOSFET region PR and the NMOSFET region NR may extend in the second direction D2.

A first active pattern AP1 and a second active pattern AP2 may be defined by a trench TR formed on an upper portion of the substrate 100. The first active pattern AP1 may be provided on the PMOSFET region PR. The second active pattern AP2 may be provided on the NMOSFET region NR.

A device isolation layer ST may fill the trench TR. The device isolation layer ST may be formed on sidewalls of a backside active contact BAC and a first backside separation structure BST1, which will be described later. The device isolation layer ST may include a silicon-based insulating material (e.g., a silicon oxide layer). The device isolation layer ST may not be formed on first and second channel patterns CH1 and CH2, which will be described later.

A first channel pattern CH1 may be provided on a first active pattern AP1. A second channel pattern CH2 may be provided on a second active pattern AP2. Each of the first channel pattern CH1 and the second channel pattern CH2 may include a first semiconductor pattern SP1, a second semiconductor pattern SP2, and a third semiconductor pattern SP3 that are arranged in a third direction D3 (or vertical direction) intersecting the first direction D1 and the second direction D2. The first to third semiconductor patterns SP1, SP2, and SP3 may be spaced apart in the third direction D3 with a gate electrode GE therebetween.

Each of the first to third semiconductor patterns SP1, SP2, and SP3 may include silicon (Si), germanium (Ge), or silicon-germanium (SiGe). For example, each of the first to third semiconductor patterns SP1, SP2, and SP3 may include crystalline silicon. Each of the first to third semiconductor patterns SP1, SP2, and SP3 may be referred to as a nanosheet.

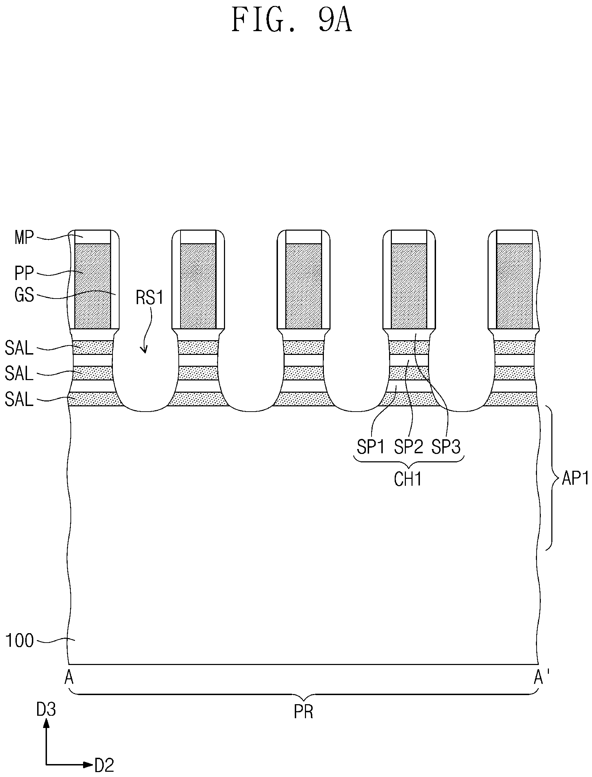

A plurality of first source/drain patterns SD1 may be provided on the first active pattern AP1. A plurality of first recesses RS1 (e.g., in FIG. 9A) may be formed on the first active pattern AP1. The first source/drain patterns SD1 may be provided in each of the first recesses RS1 (e.g., in FIG. 9A). Each of the first source/drain patterns SD1 may be or include an impurity region of a first conductivity type (e.g., p-type). The first channel pattern CH1 may be interposed between two adjacent first source/drain patterns SD1 in the second direction D2. The first to third semiconductor patterns SP1, SP2, and SP3 may connect the two adjacent first source/drain patterns SD1 to each other.

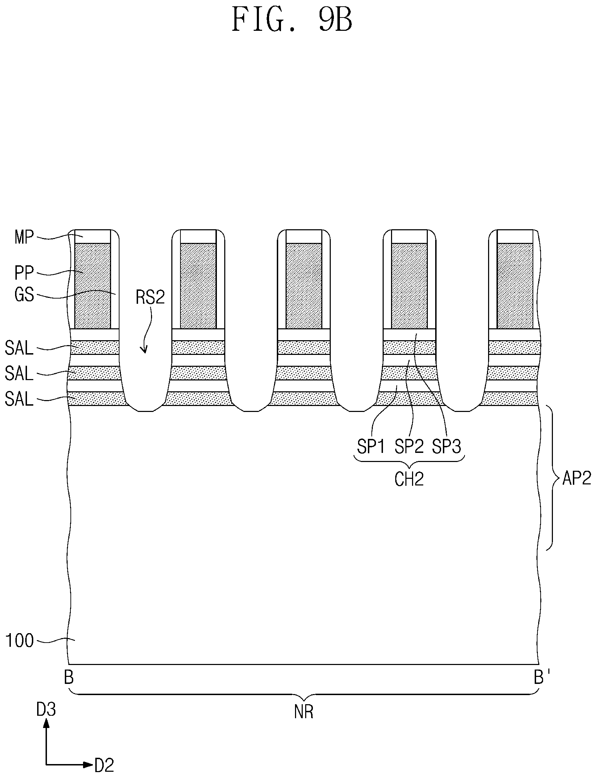

A plurality of second source/drain patterns SD2 may be provided on the second active pattern AP2. A plurality of second recesses RS2 (e.g., in FIG. 9B) may be formed on the second active pattern AP2. The second source/drain patterns SD2 may be provided in each of the second recesses RS2 (e.g., in FIG. 9A). Each of the second source/drain patterns SD2 may be or include an impurity region of a second conductivity type (e.g., n-type). The second channel pattern CH2 may be interposed between two adjacent second source/drain patterns SD2. The first to third semiconductor patterns SP1, SP2, and SP3 may connect the two adjacent second source/drain patterns SD2 to each other.

The first and second source/drain patterns SD1 and SD2 may be epitaxial patterns formed through a selective epitaxial growth (SEG) process. For example, an upper surface of each of the first and second source/drain patterns SD1 and SD2 may be positioned at substantially the same level as an upper surface of the third semiconductor pattern SP3 in the third direction D3. As another example, the upper surface of each of the first and second source/drain patterns SD1 and SD2 may be at a level higher than the upper surface of the third semiconductor pattern SP3 in the third direction D3.

The first source/drain patterns SD1 may include a semiconductor element (e.g., SiGe) having a lattice constant greater than a lattice constant of the semiconductor material of the first channel pattern CH1. Accordingly, the first source/drain patterns SD1 may provide compressive stress to the first channel pattern CH1 therebetween. The second source/drain patterns SD2 may include the same semiconductor material (e.g., Si) as the second channel pattern CH2.

Each of the first source/drain patterns SD1 may include a buffer layer BFL and a main layer MAL on the buffer layer BFL. Referring again to FIG. 5A, the buffer layer BFL may be formed on an inner wall of the first recess RS1 (e.g., in FIG. 9A). The main layer MAL may fill the remaining region of the first recess RS1 (e.g., in FIG. 9A). A volume of the main layer MAL may be larger than a volume of the buffer layer BFL. Each of the buffer layer BFL and main layer MAL may include silicon-germanium (SiGe). For example, the buffer layer BFL may include a relatively low concentration of germanium (Ge). In another embodiment, the buffer layer BFL may include only silicon (Si) excluding germanium (Ge). For example, a concentration of germanium (Ge) in the buffer layer BFL may be 0 at% to 30 at%.

The main layer MAL may include a relatively high concentration of germanium (Ge). For example, a concentration of germanium (Ge) in the main layer MAL may be 30 at% to 70 at%. A concentration of germanium (Ge) in the main layer MAL may increase along the third direction D3 away from the substrate 100. For example, the main layer MAL adjacent to the buffer layer BFL may have a germanium (Ge) concentration of about 40 at%, but an upper portion of the main layer MAL may have a germanium (Ge) concentration of about 60 at%.

Each of the buffer layer BFL and the main layer MAL may include impurities (e.g., boron, gallium, or indium) that cause the first source/drain pattern SD1 to be p-type. An impurity concentration of each of the buffer layer BFL and the main layer MAL may be 1E¹⁸ atoms/cm³ to 5E²² atoms/cm³. A concentration of impurities in the main layer MAL may be greater than a concentration of impurities in the buffer layer BFL.

The buffer layer BFL may protect the main layer MAL during a process of replacing second semiconductor layers SAL, which will be described later, with first to third inner electrodes PO1, PO2, and PO3 of the gate electrode GE. The buffer layer BFL may prevent an etchant that removes the second semiconductor layers SAL from penetrating into the main layer MAL and etching the main layer MAL.

Each of the second source/drain patterns SD2 may include silicon (Si). The second source/drain pattern SD2 may further include impurities (e.g., phosphorus, arsenic, or antimony) that cause the second source/drain patterns SD2 to be n-type. An impurity concentration of the second source/drain pattern SD2 may be 1E¹⁸ atoms/cm³ to 5E²² atoms/cm³.

The gate electrodes GE may be provided crossing the first and second channel patterns CH1 and CH2 and extending in the first direction D1. The gate electrodes GE may be arranged in the second direction D2 with a first pitch. Each of the gate electrodes GE may vertically overlap the first and second channel patterns CH1 and CH2.

The gate electrode GE may include a first inner electrode PO1 interposed between an active pattern (first active pattern AP1 or second active pattern AP2) and the first semiconductor pattern SP1, a second inner electrode PO2 interposed between SP1 and the second semiconductor pattern SP2, a third inner electrode PO3 interposed between the second semiconductor pattern SP2 and the third semiconductor pattern SP3, and an outer electrode PO4 on the third semiconductor pattern SP3.

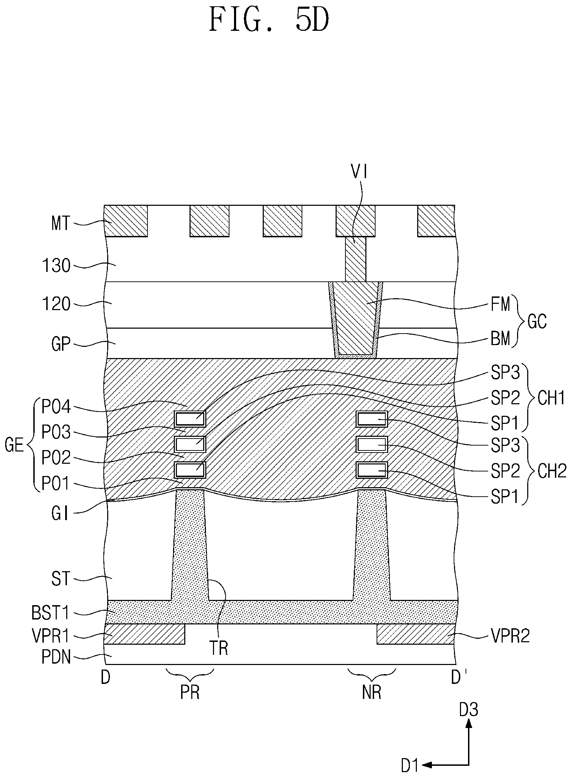

Referring to FIG. 5D, the gate electrode GE may be provided on an upper surface, a bottom surface, and sidewalls of each of the first to third semiconductor patterns SP1, SP2, and SP3. In other words, the transistor according to this embodiment may be a three-dimensional field effect transistor (e.g., multi-bridge channel FET (MBCFET) or gate-all-around FET (GAAFET)) in which the gate electrode GE three-dimensionally surrounds a channel.

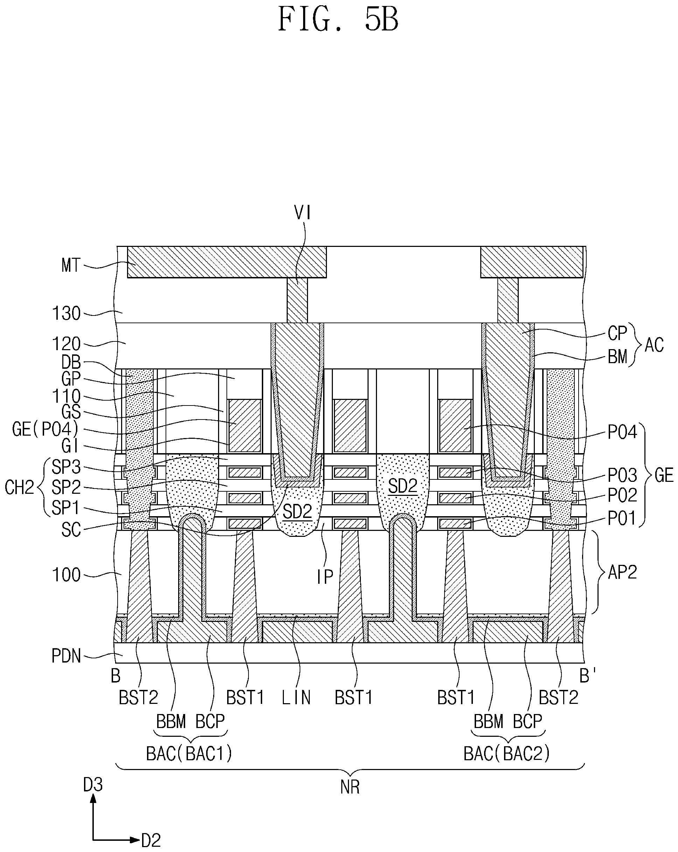

Gate spacers GS (Fig. 5A and 5B) may be disposed on both side walls of the outer electrode PO4 of the gate electrode GE. The gate spacers GS may extend in the first direction D1 along the gate electrode GE. Upper surfaces of the gate spacers GS may be higher than upper surfaces of the gate electrode GE. The upper surfaces of the gate spacers GS may be coplanar with an upper surface of a first interlayer insulating layer 110, which will be described later. The gate spacers GS may include at least one of SiCN, SiCON, and SiN. As another example, the gate spacers GS may include a multi-layer made of at least two of SiCN, SiCON, and SiN.

A gate capping pattern GP may be provided on the gate electrode GE. The gate capping pattern GP may extend in the first direction D1 along the gate electrode GE. The gate capping pattern GP may include a material that has etch selectivity with respect to first and second interlayer insulating layers 110 and 120, which will be described later. Specifically, the gate capping pattern GP may include at least one of SiON, SiCN, SiCON, and SiN.

A gate insulating layer GI may be interposed between the gate electrode GE and the first channel pattern CH1 and between the gate electrode GE and the second channel pattern CH2. The gate insulating layer GI may be formed on an upper surface, a bottom surface, and sidewalls of each of the first to third semiconductor patterns SP1, SP2, and SP3. The gate insulating layer GI may also be formed on an upper surface of the device isolation layer ST below the gate electrode GE. The gate insulating layer GI may be in contact with the upper surface of the backside separation structure BST1 below the gate electrode GE (refer to FIG. 5D). The gate insulating layer GI may be interposed between the first inner electrode PO1 and the first backside separation structure BST1.

In one embodiment, the gate insulating layer GI may include a silicon oxide layer, a silicon oxynitride layer, and/or a high-k dielectric layer. The high-k dielectric layer may include a high dielectric constant material that has a higher dielectric constant than the silicon oxide layer. As an example, the high dielectric constant material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, and strontium titanium, oxide, lithium oxide, aluminum oxide, lead scandium tantalum oxide, and lead zinc niobate.

The gate electrode GE may include a first metal pattern and a second metal pattern on the first metal pattern. The first metal pattern may be provided on the gate insulating layer GI and adjacent to the first to third semiconductor patterns SP1, SP2, and SP3. The first metal pattern may include a work function metal that adjusts the threshold voltage of a transistor. As a thickness and composition of the first metal pattern are adjusted, the certain threshold voltage of the transistor may be achieved. For example, the first to third inner electrodes PO1, PO2, and PO3 of the gate electrode GE may be formed of a first metal pattern that is a work function metal.

The first metal pattern may include a metal nitride layer. For example, the first metal pattern may include nitrogen (N) and at least one metal selected from the group consisting of titanium (Ti), tantalum (Ta), aluminum (Al), tungsten (W), and molybdenum (Mo). Furthermore, the first metal pattern may further include carbon (C). The first metal pattern may include a plurality of stacked work function metal layers.

The second metal pattern may include a metal with lower resistance than the first metal pattern. For example, the second metal pattern may include at least one of tungsten (W), aluminum (Al), titanium (Ti), and tantalum (Ta), not being limited thereto. For example, the outer electrode PO4 of the gate electrode GE may include a first metal pattern and a second metal pattern on the first metal pattern.

Referring again to FIG. 5B, inner spacers IP may be provided on the NMOSFET regions NR. The inner spacers IP may be provided on the second active pattern AP2. The inner spacers IP may be interposed between the first to third inner electrodes PO1, PO2, and PO3 of the gate electrode GE and the second source/drain pattern SD2, respectively. The inner spacers IP may be in direct contact with the second source/drain pattern SD2. Each of the first to third inner electrodes PO1, PO2, and PO3 of the gate electrode GE may be spaced apart from the second source/drain pattern SD2 by the inner spacer IP.

A first interlayer insulating layer 110 may be provided on the substrate 100. The first interlayer insulating layer 110 may be provided on sidewalls of the gate spacers GS and the first and second source/drain patterns SD1 and SD2. An upper surface of the first interlayer insulating layer 110 may be substantially coplanar with an upper surface of the gate capping pattern GP and an upper surface of the gate spacer GS. A second interlayer insulating layer 120 may be disposed on the first interlayer insulating layer 110 and on the gate capping pattern GP. A third interlayer insulating layer 130 may be provided on the second interlayer insulating layer 120. As an example, the first to third interlayer insulating layers 110, 120, and 130 may include a silicon oxide layer.

Upper active contacts AC may be provided through the first and second interlayer insulating layers 110 and 120 and electrically connected to the first and second source/drain patterns SD1 and SD2, respectively. When viewed in a plan view, the upper active contact AC may have a bar shape extending in the first direction D1.

The upper active contact AC may be a self-aligned contact. For example, the upper active contact AC may be formed in a self-aligned manner using the gate capping pattern GP and the gate spacer GS. For example, the upper active contact AC may be formed on at least a portion of a sidewall of the gate spacer GS.

The upper active contact AC may include a conductive pattern CP and a barrier pattern BM surrounding the conductive pattern CP. For example, the conductive pattern CP may include at least one of aluminum, copper, tungsten, molybdenum, and cobalt, not being limited thereto. The barrier pattern BM may be formed on sidewalls and a bottom surface of the conductive pattern CP. The barrier pattern BM may include a metal layer/metal nitride layer. The metal layer may include at least one of titanium, tantalum, tungsten, nickel, cobalt, and platinum, not being limited thereto. The metal nitride layer may include at least one of titanium nitride (TiN), tantalum nitride (TaN), tungsten nitride (WN), nickel nitride (NiN), cobalt nitride (CoN), and platinum nitride (PtN), not being limited thereto.

A metal-semiconductor compound layer SC, for example, a silicide layer may be interposed between the upper active contact AC and the first source/drain pattern SD1 and between the upper active contact AC and the second source/drain pattern SD2, respectively. The upper active contact AC may be electrically connected to the source/drain patterns SD1 and SD2 through the metal-semiconductor compound layer SC. For example, the metal-semiconductor compound layer SC may include at least one of titanium-silicide, tantalum-silicide, tungsten-silicide, nickel-silicide, and cobalt-silicide, not being limited thereto.

Referring again to FIG. 5D, a gate contact GC may be provided that penetrate the second interlayer insulating layer 120 and the gate capping pattern GP to be connected to the gate electrode GE. The gate contact GC may be in direct contact with an upper surface of the outer electrode PO4. The gate contact GC may include a gate contact pattern FM and a barrier pattern BM surrounding the gate contact pattern FM. For example, the gate contact pattern FM may include at least one of aluminum, copper, tungsten, molybdenum, and cobalt, not being limited thereto. The barrier pattern BM may be formed on sidewalls and a bottom surface of the gate contact pattern FM. The barrier pattern BM may include a metal layer/metal nitride layer. The metal layer may include at least one of titanium, tantalum, tungsten, nickel, cobalt, and platinum, not being limited thereto. The metal nitride layer may include at least one of titanium nitride (TiN), tantalum nitride (TaN), tungsten nitride (WN), nickel nitride (NiN), cobalt nitride (CoN), and platinum nitride (PtN), not being limited thereto.

Referring to FIGS. 4, 5A, 5B, 5D, and 6, two upper separation structures DB facing each other in the second direction D2 may be provided on both sides of the single height cell SHC. For example, the two upper separation structures DB may extend in the first direction D1 parallel to the gate electrodes GE. The upper separation structure DB may penetrate the first channel pattern CH1 in the third direction D3.

The upper separation structure DB may include a first portion DB_1 that faces a side of the first source/drain pattern SD1 and extends vertically in the third direction D3, a second portion DB_2 that protrudes horizontally from the first portion DB_1, and a third portion DB_3 that is connected to the first portion DB_1 and disposed in the substrate 100. A width of the first portion DB_1 may gradually decrease in the third direction D3 toward a bottom thereof and the substrate 100. The second portion DB_2 of the upper separation structure DB may protrude toward the side of the first source/drain pattern SD1. The second portion DB_2 of the upper separation structure DB and the first source/drain pattern SD1 may be spaced apart with the remaining gate insulating layer RGI interposed therebetween. The remaining gate insulating layer RGI may include the same or similar material as the gate insulating layer GI described above. The third portion DB_3 may be connected to a second backside separation structure BST2, which will be described later. As an example, the third portion DB_3 may be formed on a portion of a sidewall of the second backside separation structure BST2. The lowermost end of the upper separation structure DB (i.e., the lowermost end of the third portion DB_3) may be positioned at a level lower than a bottom surface of the gate insulating layer GI surrounding the first inner electrode PO1, and may be appropriately changed at a line positioned at a level higher than a bottom surface of the substrate 100.

A first backside separation structure BST1 may be provided under the gate electrode GE. The first backside separation structure BST1 may penetrate the substrate 100 and extend to a bottom surface of the gate insulating layer GI surrounding the first inner electrode PO1. For example, the first backside separation structure BST1 may be in direct contact with the bottom surface of the gate insulating layer GI. The first backside separation structure BST1 may extend in the first direction D1 and fill the trench TR between the device isolation layers ST.

The first backside separation structure BST1 may separate the backside active contact BAC electrically connected to the source/drain pattern SD1 or SD2 for each unit in the transistor. For example, the first backside separation structure BST1 may electrically separate the backside active contacts BAC so that a drain voltage or a source voltage is individually applied to the source/drain pattern SD1 or SD2, respectively. In addition, the first backside separation structure BST1 may include an insulating material and may separate the substrate 100 in the second direction D2. Accordingly, the first backside separation structure BST1 may prevent leakage current between two adjacent source/drain patterns SD1 and between two adjacent source/drain patterns SD2 in the second direction D2 from flowing through the substrate 100.

Under the upper separation structure DB, a second backside separation structure BST2 may be provided that vertically overlaps the upper separation structure DB. The second backside separation structure BST2 may be connected to the upper separation structure DB in the third direction D3. The upper separation structure DB and the second backside separation structure BST2 may be provided at each of a left boundary portion and a right boundary of the single height cell SHC (e.g., in FIG. 4). The second backside separation structure BST2 may extend in the first direction D1.

The first backside separation structure BST1 and the second backside separation structure BST2 may face each other in the second direction D2. A width of the first and second backside separation structures BST1 and BST2 may gradually increase in the third direction D3 toward a bottom thereof away from the upper separation structure DB and the gate electrode GE, respectively. A bottom surface of the first backside separation structure BST1 may be substantially coplanar with a bottom surface of the second backside separation structure BST2. The bottom surfaces of the first and second backside separation structures BST1 and BST2 may be positioned at a level lower than a bottom surface of the substrate 100.

The first and second backside separation structures BST1 and BST2 may include an insulating material. As an example, the first and second backside separation structures BST1 and BST2 may each include a silicon-based insulating material and may include at least one of silicon oxide, silicon nitride, and silicon oxynitride, not being limited thereto. As another example, the first and second backside separation structures BST1 and BST2 may each include an insulating material containing metal (e.g., AlO, TiO₂, AlN, etc.).

A power transmission network layer PDN may be provided under the substrate 100 and the device isolation layer ST. For example, the power transmission network layer PDN may be disposed under the first and second backside separation structures BST1 and BST2 and a backside active contact BAC, which will be described later. The power transmission network layer PDN may include first and second lower power lines VPR1 and VPR2 that apply a power voltage (e.g., power or ground voltage). The first and second lower power lines VPR1 and VPR2 may extend parallel to each other in the second direction D2. The power transmission network layer PDN may further include a plurality of lower wires connected to the first and second lower power lines VPR1 and VPR2.

In one embodiment, the first lower power line VPR1 may vertically overlap the PMOSFET region PR. The second lower power line VPR2 may vertically overlap the NMOSFET region NR. The first and second lower power lines VPR1 and VPR2 may include at least one of copper, molybdenum, tungsten, and ruthenium, not being limited thereto.

Backside active contacts BAC may be provided under the substrate 100. The backside active contacts BAC may include first backside active contacts BAC1 electrically connected to the source/drain patterns SD1 and SD2, and second backside active contacts BAC2 not electrically connected to the source/drain pattern SD1 and SD2. For example, the first backside active contact BAC1 and the second backside active contact BAC2 may be alternately arranged in the second direction D2.

The first backside active contacts BAC1 may be connected to source/drain patterns SD1 and SD2 that are not connected to the upper active contacts AC. Upper portions of the first backside active contacts BAC1 may penetrate the substrate 100 to be connected to the source/drain patterns SD1 and SD2, and lower portions of the first backside active contacts BAC1 have relatively large widths under the substrate 100. The lower portions of the first backside active contacts BAC1 may be in contact with sidewalls of the backside separation structures BST1 and BST2.

The first backside active contact BAC1 may have a shape of a conductive pillar that vertically and electrically connects the power transmission network layer PDN and the source/drain patterns SD1 and SD2. For example, the first backside active contacts BAC1 may have a shape of a conductive pillar to vertically and electrically connect the lower power lines VPR1 and VPR2 and the source/drain patterns SD1 and SD2, respectively. A source voltage or a drain voltage may be applied to the source/drain patterns SD1 and SD2 through the first backside active contacts BAC1.

Metal-semiconductor compound layers may be provided between the first backside active contact BAC1s and the source/drain patterns SD1 and SD2. For example, the metal-semiconductor compound layer may be a silicide layer. The first backside active contact BAC1 may be electrically connected to the first source/drain pattern SD1 or the second source/drain pattern SD2 through the metal-semiconductor compound layer SC. For example, the metal-semiconductor compound layer may include at least one of titanium-silicide, tantalum-silicide, tungsten-silicide, nickel-silicide, and cobalt-silicide, not being limited thereto.

The second backside active contact BAC2 may be disposed under the source/drain patterns SD1 and SD2 connected to the upper active contacts AC, respectively. The second backside active contacts BAC2 may not penetrate the substrate 100. The second backside active contacts BAC2 may be in contact with sidewalls of the backside separation structures BST1 and BST2, respectively.

The backside active contact BAC may include a backside conductive pattern BCP and a backside barrier pattern BBM surrounding the backside conductive pattern BCP. The backside barrier pattern BBM may be formed on sidewalls and an upper surface of the backside conductive pattern BCP. The backside barrier pattern BBM may be in contact with the substrate 100, a liner layer LIN, and sidewalls of the backside separation structures BST1 and BST2. For example, the backside barrier pattern BBM may include a metal layer/metal nitride layer. The metal layer may include at least one of titanium, tantalum, tungsten, nickel, cobalt, and platinum. The metal nitride layer may include at least one of titanium nitride (TiN), tantalum nitride (TaN), tungsten nitride (WN), nickel nitride (NiN), cobalt nitride (CoN), and platinum nitride (PtN), not being limited thereto. A bottom surface of the backside conductive pattern BCP may be substantially coplanar with bottom surfaces of the backside separation structures BST1 and BST2. As an example, the backside conductive pattern BCP may include at least one of aluminum, copper, tungsten, molybdenum, and cobalt, not being limited thereto.

A lower insulating pattern 140 may be disposed below the device isolation layer ST. A sidewall of the lower insulating pattern 140 may be in contact with the backside barrier pattern BBM. The lower insulating pattern 140 may include a silicon-based insulating material.

A liner layer LIN may be interposed between a bottom surface of the substrate 100 and the backside active contact BAC and below the device isolation layer ST. As an example, the liner layer LIN may include at least one of silicon nitride and silicon oxynitride.

Referring again to FIGS. 4 and 5A to 5D, metal wirings MT and vias VI may be provided in the third interlayer insulating layer 130. The via VI may be placed under the metal wiring MT. The upper active contact AC and the metal wiring MT may be electrically connected through the via VI.

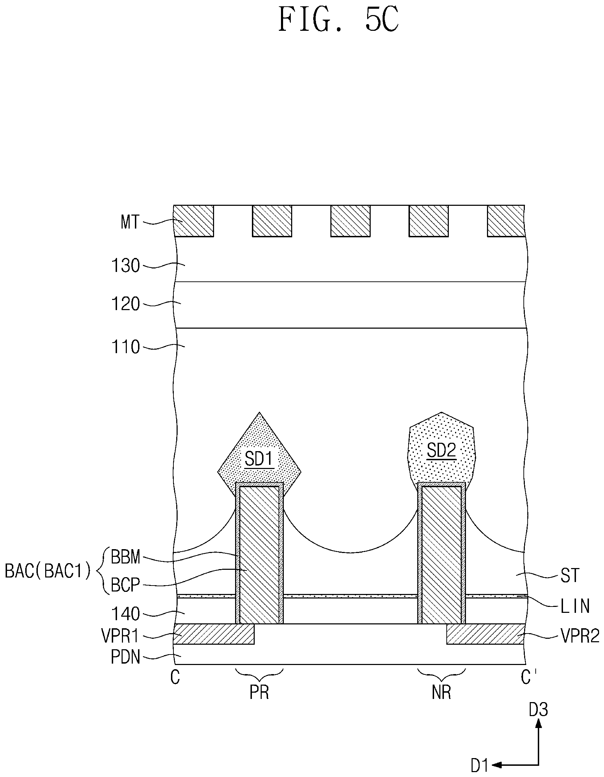

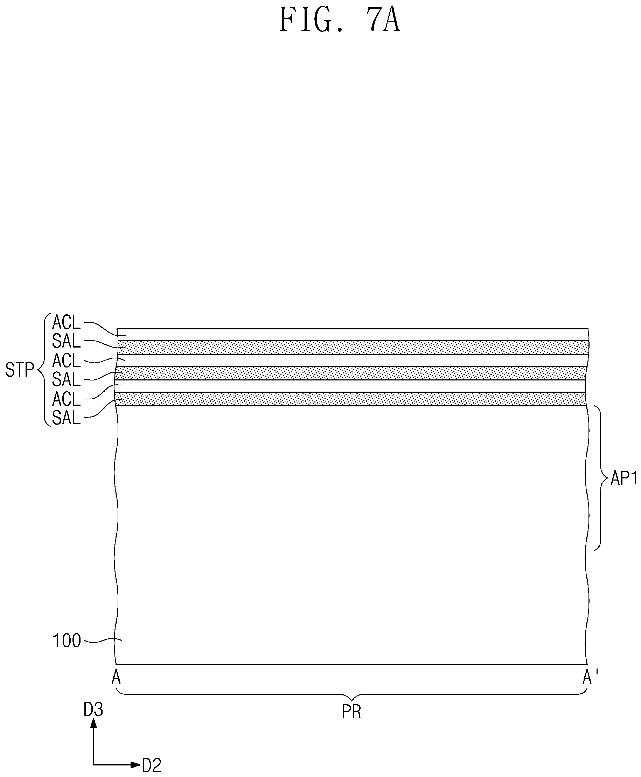

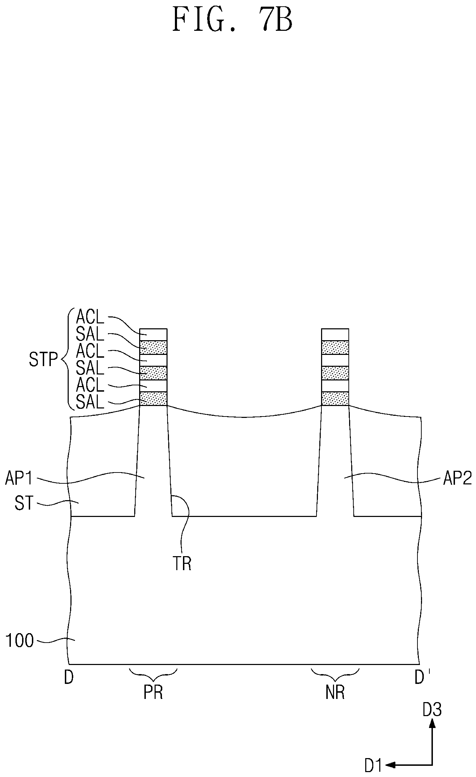

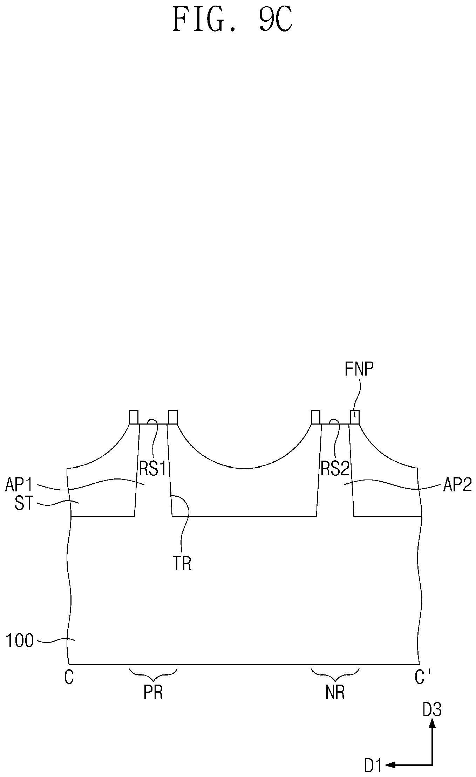

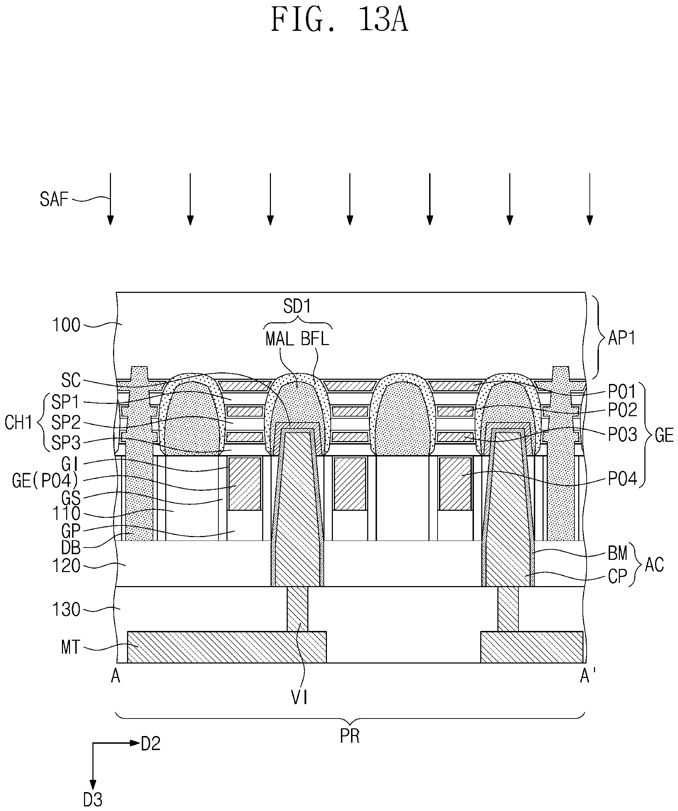

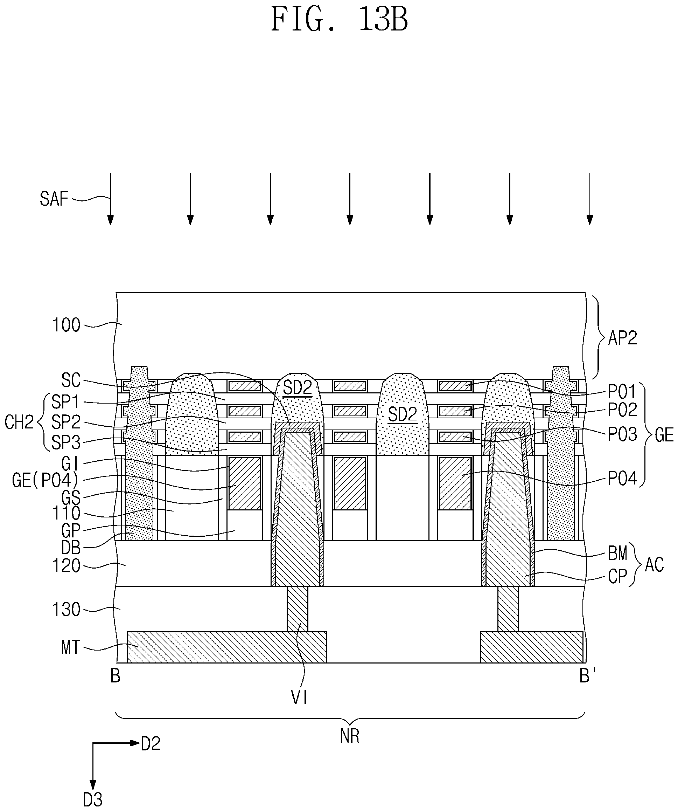

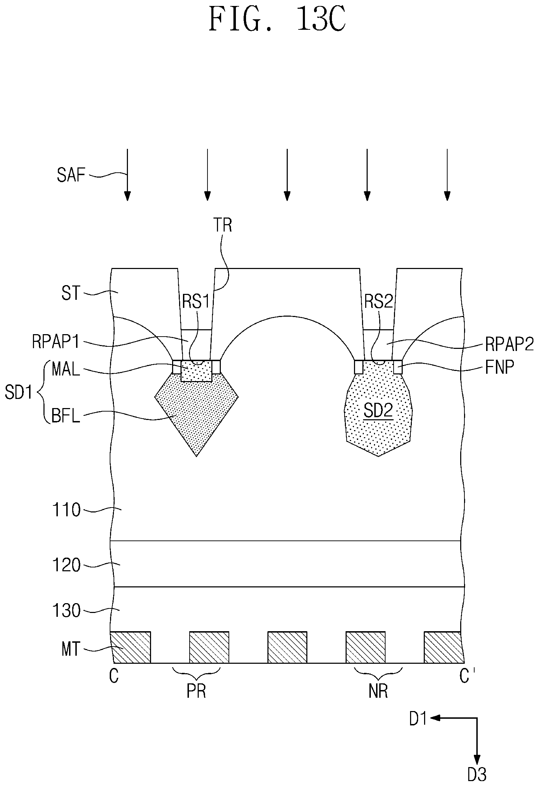

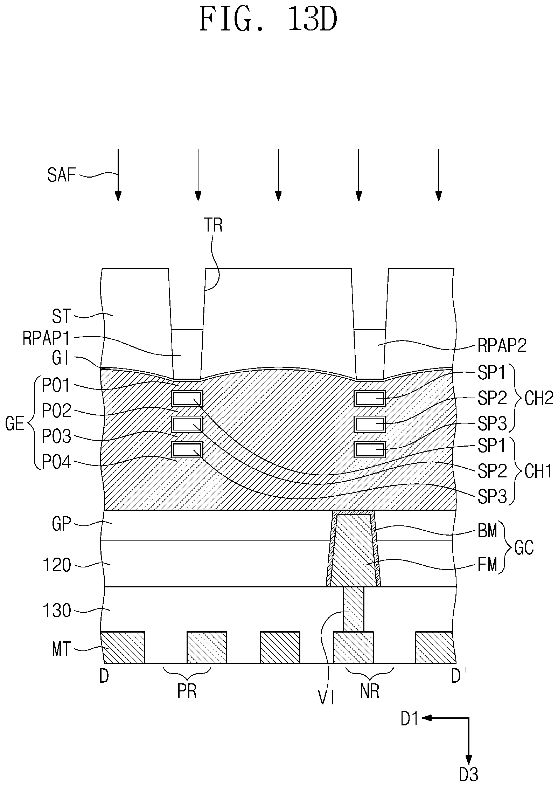

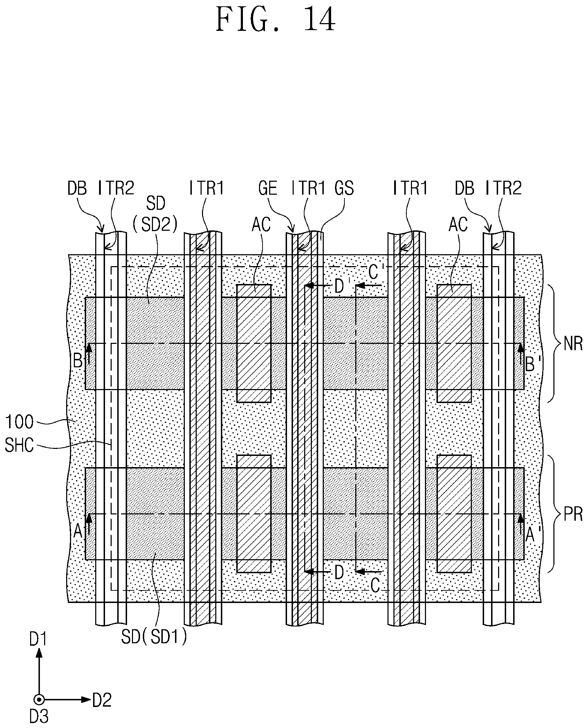

FIGS. 7A to 17D are diagrams showing a method of manufacturing a semiconductor device according to one or more embodiments. FIGS. 7A, 8A, 9A, 10A, 11A, 12A, 13A, 15A, 16A and 17A are cross-sectional views corresponding to FIG. 5A, and show a sequential flow of a manufacturing method. FIGS. 9B, 10B, 11B, 12B, 13B, 15B, 16B and 17B are cross-sectional views corresponding to FIG. 5B. FIGS. 9C, 10C, 12C, 13C, 15C, 16C and 17C are cross-sectional views corresponding to FIG. 5C. FIGS. 7B, 8B, 11C, 12D, 13D, 15D, 16D and 17D are cross-sectional views corresponding to FIG. 5D. FIG. 13 is a plan view showing a manufacturing method according to an embodiment, and FIGS. 14A to 14D are cross-sectional views taken along lines A-A', B-B', C-C', and D-D' of FIG. 13A to 13D.

Referring to FIGS. 7A and 7B, a substrate 100 including PMOSFET regions PR and NMOSFET regions NR may be provided. For example, the substrate 100 may be a silicon wafer.

First semiconductor layers ACL and second semiconductor layers SAL may be formed on the substrate 100 to be alternately stacked. The first semiconductor layers ACL may include one of silicon (Si), germanium (Ge), and silicon-germanium (SiGe), and the second semiconductor layers SAL may include the other of silicon (Si), germanium (Ge) and silicon-germanium (SiGe), not being limited thereto.

The second semiconductor layer SAL may include a material that may have an etch selectivity with respect to the first semiconductor layer ACL. For example, the first semiconductor layers ACL may include silicon (Si), and the second semiconductor layers SAL may include silicon-germanium (SiGe). A concentration of germanium (Ge) in each of the second semiconductor layers SAL may be 10 at% to 30 at%.

Mask patterns may be formed on the PMOSFET region PR and NMOSFET region NR, respectively, of the semiconductor substrate 100. The mask pattern may have a line shape or a bar shape in in the second direction D2.

A patterning process may be performed using the mask patterns as an etch mask, to form a trench TR defining the first active pattern AP1 and the second active pattern AP2. The first active pattern AP1 may be formed on the PMOSFET region PR. The second active pattern A2 may be formed on the NMOSFET region NR. When viewed in a plan view, the first and second active patterns AP1 and AP2 may have a shape of lines extending parallel to each other in the second direction D2. A stacked pattern STP may be formed on each of the first and second active patterns AP1 and AP2 through the patterning process.

A device isolation layer ST may be formed to fill the trench TR. For example, an insulating layer may be formed on the entire surface of the semiconductor substrate 100 to surround the first and second active patterns AP1 and AP2 and the stacked patterns STP. The device isolation layer ST may be formed by recessing the insulating layer until the stacked patterns STP are exposed. The device isolation layer ST may include an insulating material such as a silicon oxide layer.

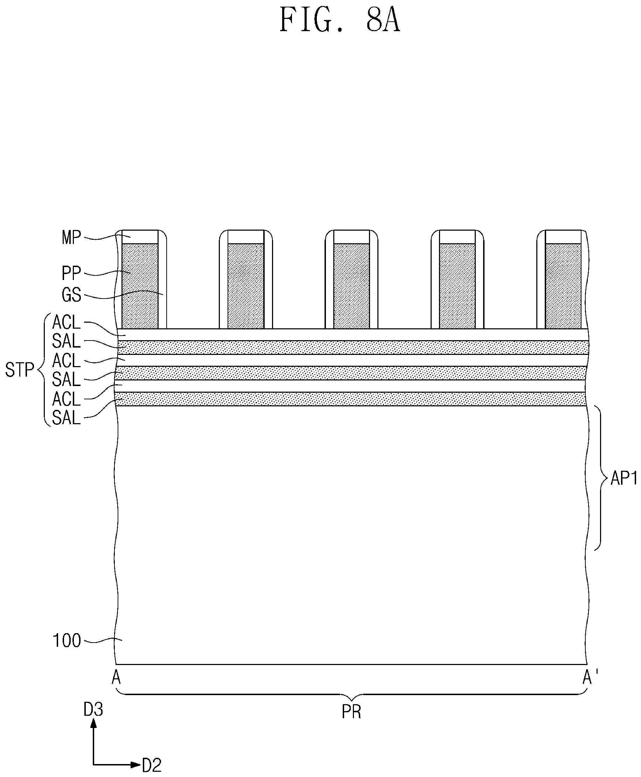

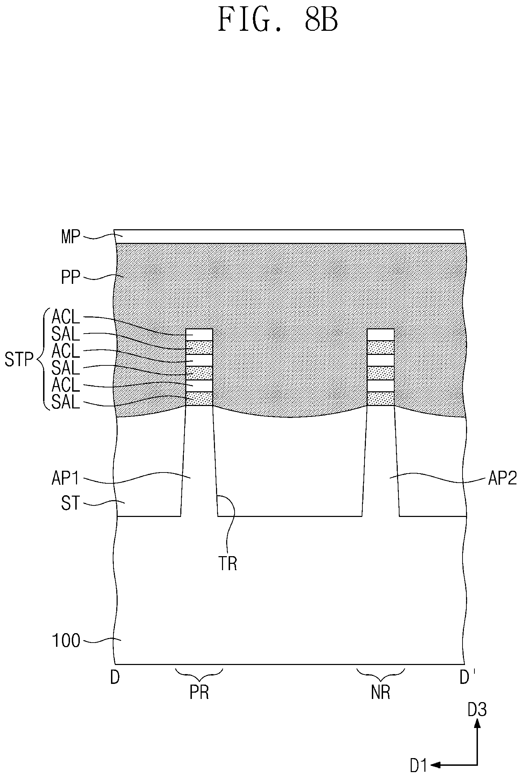

Referring to FIGS. 8A and 8B, sacrificial patterns PP may be formed across the stacked patterns STP on the semiconductor substrate 100. Each of the sacrificial patterns PP may be formed in a line shape or a bar shape extending in the first direction D1. The sacrificial patterns PP may be spaced apart from each other in the second direction D2.

Forming the sacrificial patterns PP may include forming a sacrificial layer on the entire surface of the semiconductor substrate 100, forming hard mask patterns MP on the sacrificial layer, and patterning the sacrificial layer using MP as an etch mask. The sacrificial layer may include polysilicon.

Thereafter, gate spacers GS may be formed on sidewalls of each of the sacrificial patterns PP. The gate spacer layer may include at least one of SiCN, SiCON, and SiN, not being limited thereto.

Referring to FIGS. 9A to 9C, first recesses RS1 may be formed in the stacked pattern STP on the first active pattern AP1. Second recesses RS2 may be formed in the stacked pattern STP on the second active pattern A2. Referring to FIG. 9C, while the first and second recesses RS1 and RS2 are formed, the device isolation layer ST on sides of the first and second active patterns AP1 and AP2 may be further recessed, and a fence pattern FNP may be formed on each of the first and second active patterns AP1 and AP2. The fence pattern FNP may be a portion of the remaining gate spacer GS.

The first recesses RS1 may be formed by etching the stacked pattern STP on the first active pattern AP1 using the hard mask patterns MP and the gate spacers GS as an etch mask. The first recess RS1 may be formed between two sacrificial patterns PP. The second recesses RS2 in the stacked pattern STP on the second active pattern AP2 may be formed in the same manner as the first recesses RS1.

In the process of forming the recesses RS1 and RS2, a first channel pattern CH1 and a second channel pattern CH2 may be formed. For example, in the process of forming the first recess RS1, first to third semiconductor patterns SP1, SP2, and SP3 sequentially arranged may be formed from the first semiconductor layers ACL (e.g., in FIG. 8A), respectively, to form the first channel pattern CH1. In the process of forming the second recess RS2, first to third semiconductor patterns SP1, SP2, and SP3 sequentially arranged may be formed from the first semiconductor layers ACL (e.g., in FIG. 8A), respectively, to form the second channel pattern CH2.

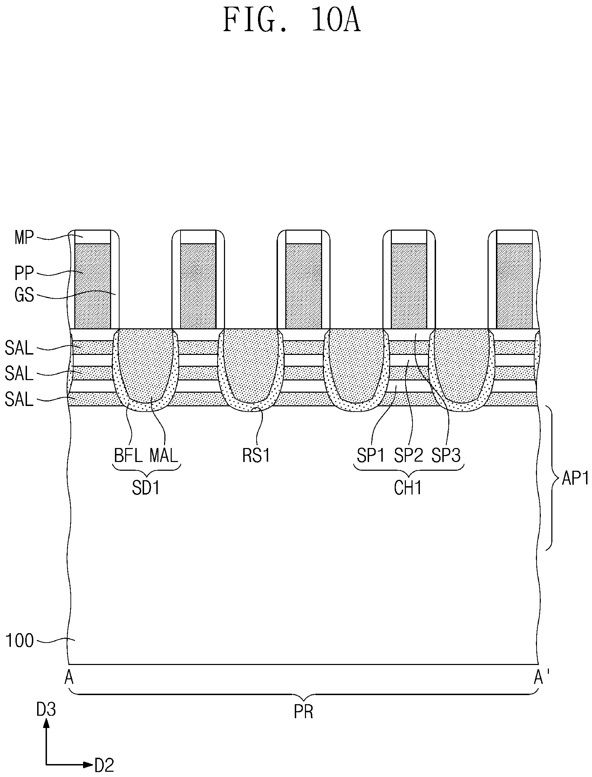

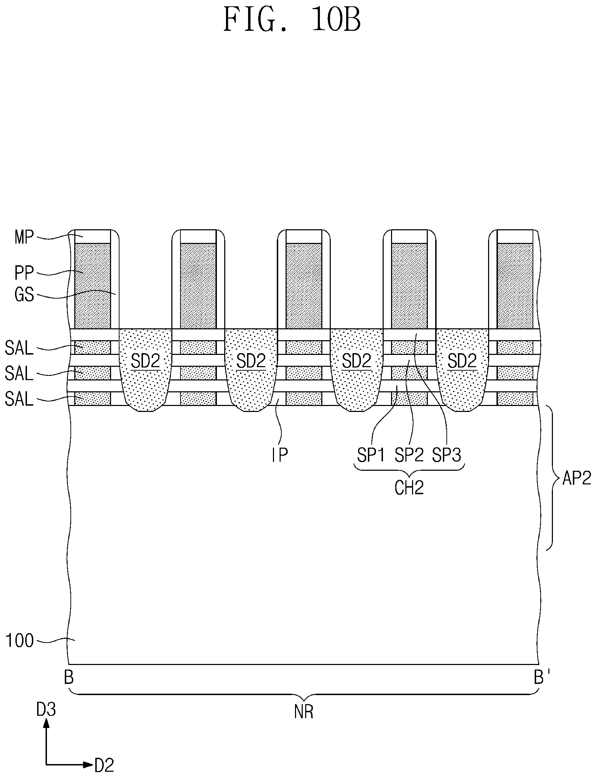

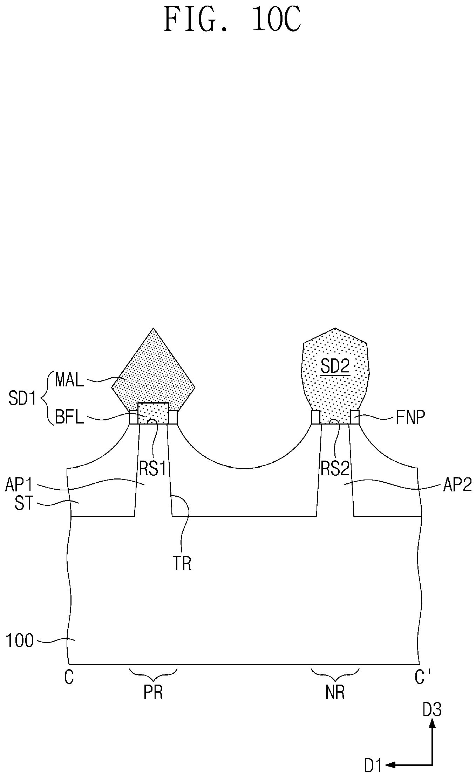

Referring to FIGS. 10A to 10C, first source/drain patterns SD1 may be formed in the first recesses RS1, respectively. A first SEG process may be performed using an inner wall of the first recess RS1 as a seed layer to form a buffer layer BFL. The buffer layer BFL may be grown using the semiconductor patterns SP1, SP2, and SP3 exposed by the first recess RS1 and the substrate 100 as a seed. As an example, the first SEG process may include a chemical vapor deposition (CVD) process or a molecular beam epitaxy (MBE) process.

The buffer layer BFL may include a semiconductor element (e.g., SiGe) having a lattice constant greater than a lattice constant of the semiconductor element of the semiconductor substrate 100. The buffer layer BFL may include a relatively low concentration of germanium (Ge). In another embodiment, the buffer layer BFL may contain only silicon (Si) excluding germanium (Ge). A concentration of germanium (Ge) in the buffer layer BFL may be 0 at% to 30 at%.

A second SEG process may be performed on the buffer layer BFL to form a main layer MAL. A main layer MAL may be formed to completely or almost completely fill the first recess RS1. The main layer MAL may contain a relatively high concentration of germanium (Ge). For example, the concentration of germanium (Ge) in the main layer MAL may be 30 at% to 70 at%.

While forming the buffer layer BFL and the main layer MAL, impurities (e.g., boron, gallium, or indium) that cause the first source/drain pattern SD1 to be p-type may be injected in-situ. As another example, after the first source/drain pattern SD1 is formed, impurities may be injected into the first source/drain pattern SD1.

Second source/drain patterns SD2 may be formed in the second recesses RS2, respectively. The second source/drain pattern SD2 may be formed by performing a selective epitaxial growth (SEG) process using an inner wall of the second recess RS2 as a seed layer. For example, the second source/drain pattern SD2 may include the same semiconductor element (e.g., Si) as that of the semiconductor substrate 100.

While forming the second source/drain pattern SD2, impurities (e.g., phosphorus, arsenic, or antimony) that cause the second source/drain pattern SD2 to be n-type may be injected in-situ. As another example, after the second source/drain pattern SD2 is formed, impurities may be injected into the second source/drain pattern SD2.

In one embodiment, before forming the second source/drain pattern SD2, a portion of the second semiconductor layer SAL exposed through the second recess RS2 may be replaced with an insulating material to form an inner spacer IP. As a result, the inner spacers IP may be formed between the second source/drain pattern SD2 and the second semiconductor layers SAL.

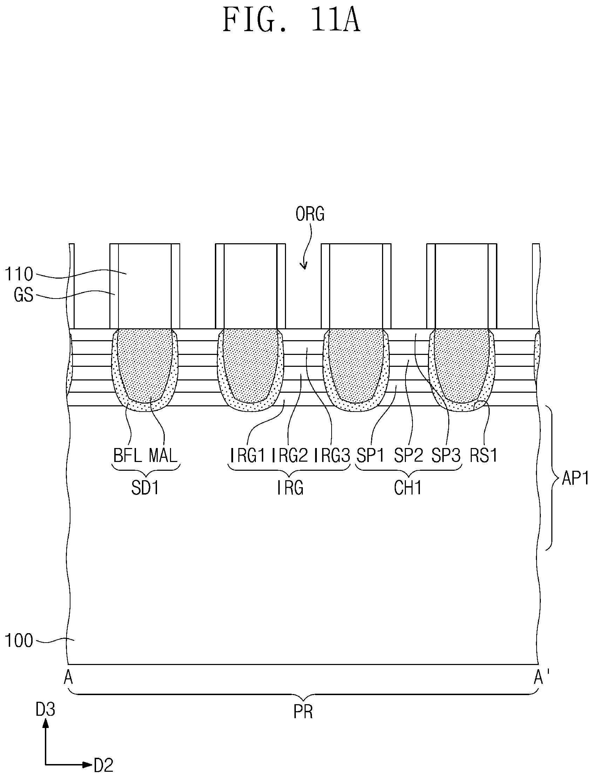

Referring to FIGS. 11A to 11C, a first interlayer insulating layer 110 may be formed on the first and second source/drain patterns SD1 and SD2, hard mask patterns MP, and gate spacers GS. As an example, the first interlayer insulating layer 110 may include a silicon oxide layer.

The first interlayer insulating layer 110 may be planarized until upper surfaces of the sacrificial patterns PP (e.g., in FIG. 10A) are exposed. The planarization of the first interlayer insulating layer 110 may be performed using an etch backside or chemical mechanical polishing (CMP) process. During the planarization process, all hard mask patterns MP may be removed. As a result, an upper surface of the first interlayer insulating layer 110 may be coplanar with upper surfaces of the sacrificial patterns PP and the gate spacers GS.

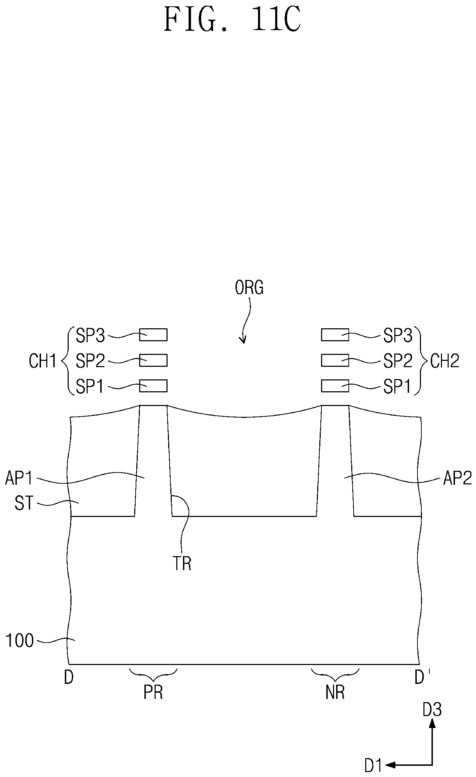

Exposed sacrificial patterns PP (e.g., in FIG. 10A) may be selectively removed. Removing the sacrificial patterns PP may include wet etching using an etchant that selectively etch polysilicon. Referring to FIG. 11C, by removing the sacrificial patterns PP (e.g., in FIG. 10A), an outer region ORG exposing the first and second channel patterns CH1 and CH2 may be formed.

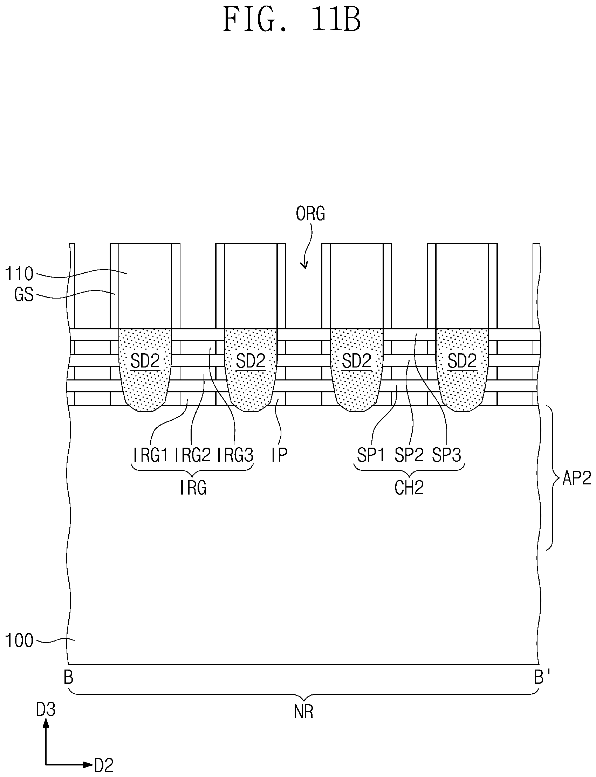

Referring to FIGS. 11A and 11B, the second semiconductor layers SAL exposed through the outer region ORG may be selectively removed to form inner regions IRG. Specifically, an etching process to selectively etch the second semiconductor layers SAL may be performed to remove only the second semiconductor layers SAL while leaving the semiconductor patterns SP1, SP2, and SP3. The etching process may have a high etch rate for silicon-germanium having a relatively high germanium concentration. For example, the etching process may have a high etch rate for silicon-germanium with a germanium concentration greater than 10 at%.

Through the etching process, the second semiconductor layers SAL (e.g., in FIG. 10A) on the PMOSFET region PR and the NMOSFET region NR may be removed. As an example, the etching process may be performed by wet etching. The etching material used in the etching process may quickly remove the second semiconductor layer SAL having a relatively high germanium concentration. Meanwhile, the first source/drain pattern SD1 on the PMOSFET region PR may be protected during the etching process due to the buffer layer BFL having a relatively low germanium concentration.

The second semiconductor layers SAL may be removed to form first to third inner regions IRG1, IRG2, and IRG3, respectively. Specifically, a first inner region IRG1 may be formed between the active patterns AP1 and AP2 and the first semiconductor pattern SP1, a second inner region IRG2 may be formed between the first semiconductor pattern SP1 and the second semiconductor pattern SP2, and a third inner region IRG3 between the second semiconductor pattern SP2 and the third semiconductor pattern SP3.

Referring again to FIG. 11C, the second semiconductor layers SAL may be selectively removed, and thus semiconductor patterns SP1, SP2, and SP3 stacked on each of the active patterns AP1 and AP2 may remain.

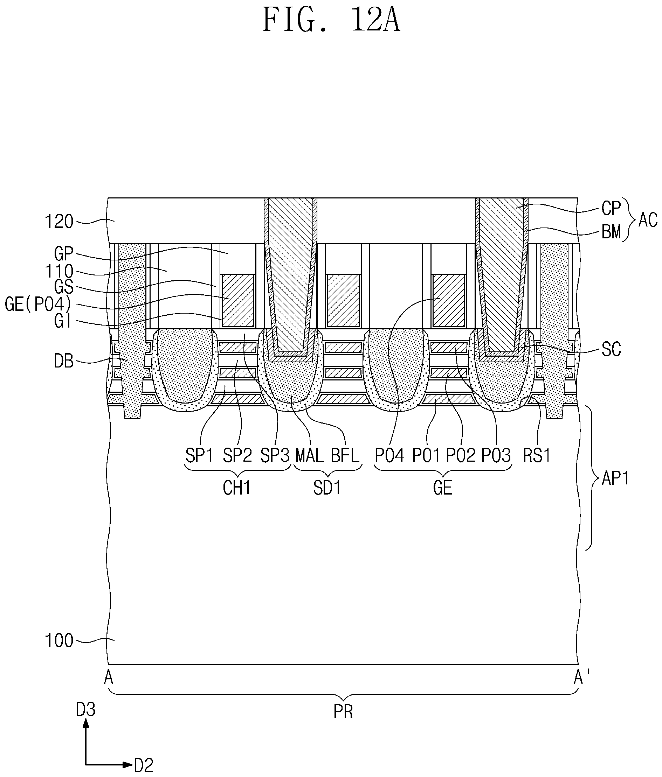

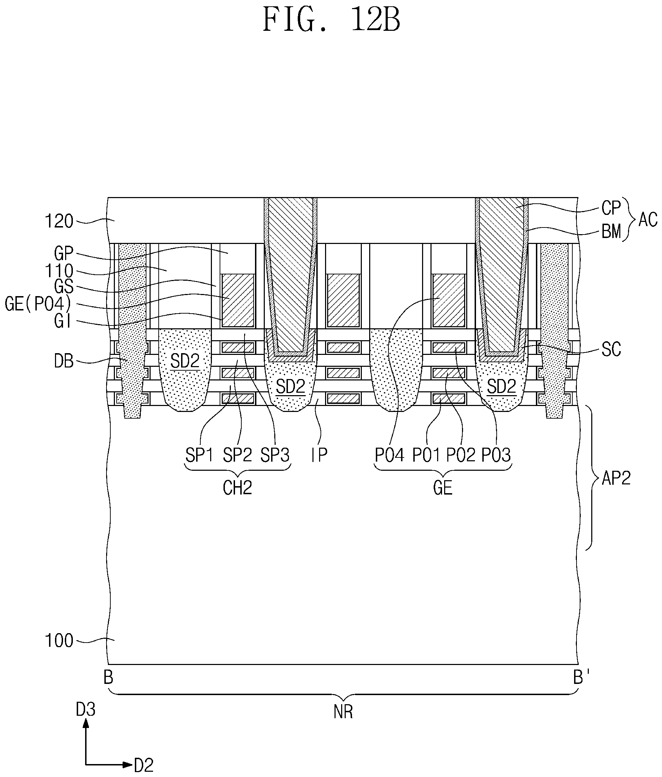

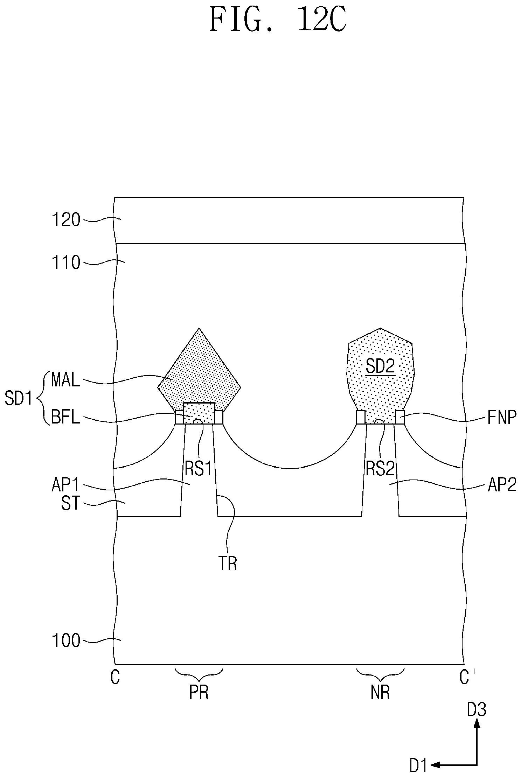

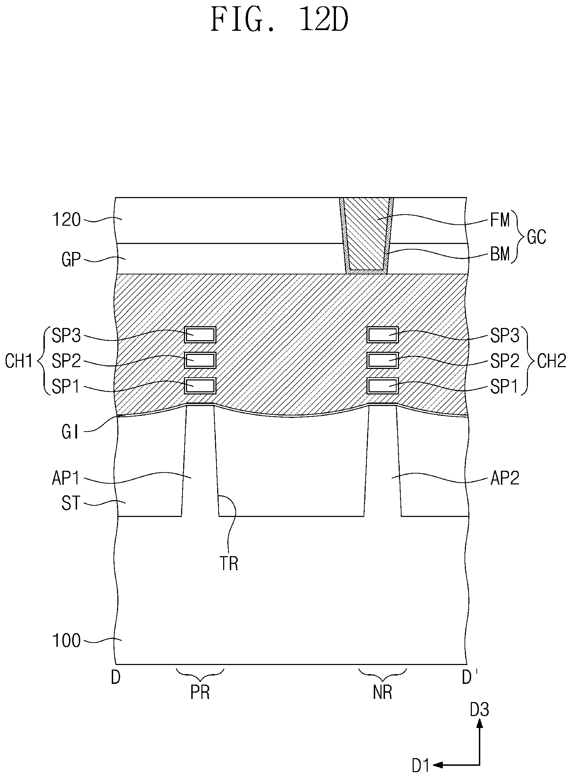

Referring to FIGS. 12A to 12D, a gate insulating layer GI may be conformally formed on the exposed semiconductor patterns SP1, SP2, and SP3. A gate electrode GE may be formed on the gate insulating layer GI. The gate electrode GE may include first to third inner electrodes PO1, PO2, and PO3 formed in the first to third inner regions IRG1, IRG2, and IRG3, respectively, and an outer electrode PO4 formed on the first to third inner electrodes PO1, PO2, and PO3. A gate capping pattern GP may be formed on the gate electrode GE.

Afterwards, an upper separation structure DB may be formed. Forming the upper separation structure DB may include partially patterning the gate capping pattern GP, the gate electrode GE, the semiconductor patterns SP1, SP2, and SP3, and the substrate 100 to form a trench. Removing the gate electrode GE in the trench through an etching process, and filling the trench with an insulating material. The trench may extend in the first direction D1. In the process of forming the trench, a portion of the substrate 100 may be removed, and in the etching process, the gate electrode GE may be selectively removed through a wet etching process. The insulating material may fill a space where the substrate 100 and the gate electrode GE have been removed.

According to one or more embodiments, a bottom surface of the upper separation structure DB may be positioned at a level higher than a bottom surface of the substrate 100, and may be formed to have a relatively a small width and height compared to a single separation structure penetrating the substrate 100. For example, a depth of the trench (or recess) may be reduced in the process of forming the upper separation structure DB. Accordingly, in the process of filling the trench (or recess) with an insulating material, insulating characteristics of the upper separation structure DB may be improved. For example, a seam may not be formed in the upper separation structure DB due to the relatively small width and height.

A second interlayer insulating layer 120 may be formed on the first interlayer insulating layer 110. As an example, the second interlayer insulating layer 120 may include a silicon oxide layer.

An upper active contact AC may be formed that penetrates the second interlayer insulating layer 120 and the first interlayer insulating layer 110 to be connected to at least one of the source/drain patterns SD1 and SD2. Forming the active contact AC may include etching the interlayer insulating layers 110 and 120 to form a trench, depositing a barrier pattern(M) in the trench, and a conductive pattern CP on the barrier pattern BM. The barrier pattern BM may be formed conformally and may include a metal layer/metal nitride layer, and the conductive pattern CP may include a low-resistance metal.

A gate contact GC may be formed that penetrates the second interlayer insulating layer 120 and the gate capping pattern GP to be connected to the gate electrode GE. Forming the gate contact GC may include etching the second interlayer insulating layer 120 and the gate capping pattern GP to form a trench, depositing a barrier pattern BM in the trench, and forming the gate contact pattern FM on the barrier pattern BM.

The top and bottom of the substrate 100 described with reference to FIGS. 8A to 12D may be reversed. In the following description with reference to FIGS. 13A to 17D, the `upper surface' and `upper portion' may refer to the `lower surface' and `lower portion' from the perspective of the three-dimensional semiconductor device described with reference FIGS. 5A to 5D, and the `lower surface' and `lower portion' may refer to the `upper surface' and `upper portion form the perspective of the manufactured 3D semiconductor device described with reference to FIGS. 5A to 5D.

Referring to FIGS. 13A to 13D, the substrate 100 may be turned over or flipped upside down so that an upper surface of the substrate 100 is exposed. A portion of the exposed semiconductor substrate 100 may be removed. For example, a portion of the substrate 100 may be removed through a planarization process SAF, and a thickness of the substrate 100 may be reduced. Furthermore, an upper surface of the device isolation layer ST may be exposed.

Thereafter, silicon (Si) may be selectively removed by performing a separate etching process. Referring to FIG. 13C, a portion of the first active pattern AP1 may be etched on the PMOSFET region PR to form a first residual active pattern RPAP1. Referring to FIG. 13D, a portion of the second active pattern AP2 may be etched on the NMOSFET region NR to form a second residual active pattern RPAP2. As the separate etching process selectively removes silicon, the device isolation layer ST may not be removed during the etching process.

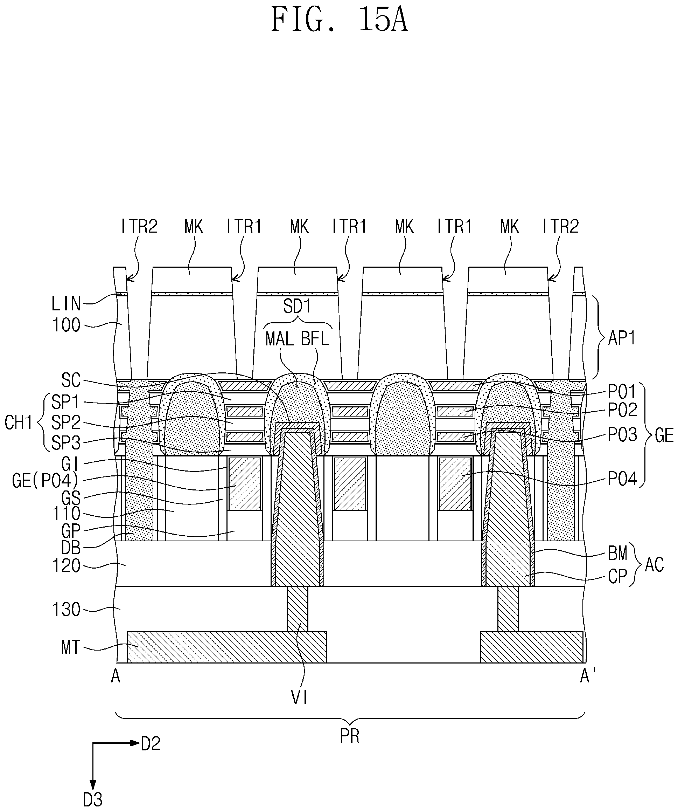

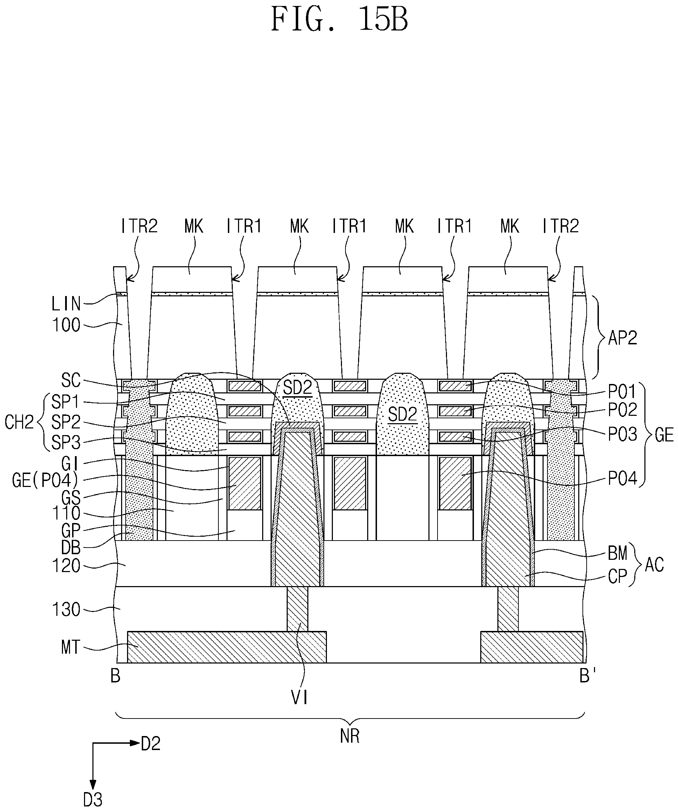

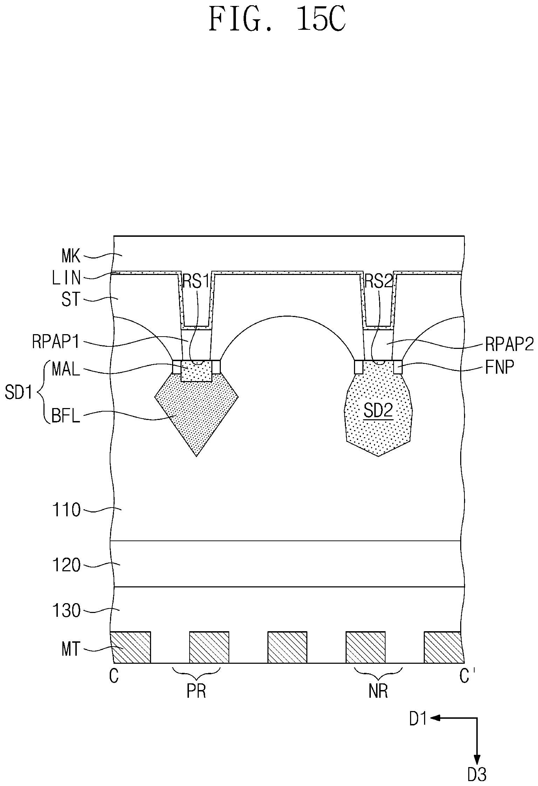

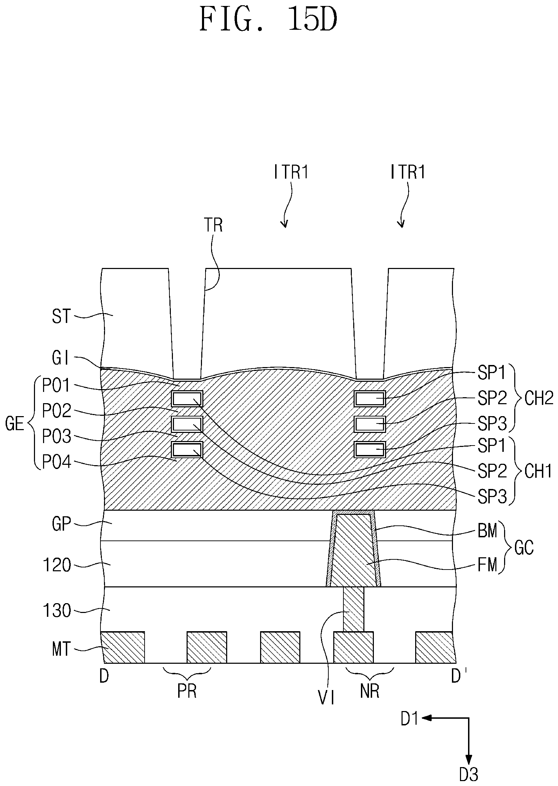

Referring to FIGS. 14 and 15A to 15D, a liner layer LIN may be conformally deposited to the upper surface of the substrate 100. The liner layer LIN may be conformally formed on the substrate 100, the first and second residual active patterns RPAP1 and RPAP2, and the device isolation layer ST. As an example, the liner layer LIN may include at least one of silicon nitride and silicon oxynitride.

Thereafter, mask patterns MK may be formed on the liner layer LIN. The mask patterns MK may extend in the first direction D1 and may be spaced apart from each other in the second direction D2. The substrate 100 may be patterned through the mask pattern MK, and first separation trenches ITR1 and second separation trenches ITR2 may be formed. The separation trenches ITR1 and ITR2 extend in the first direction D1 and may be spaced apart from each other in the second direction D2. During the patterning process, portion of the residual active patterns RPAP1 and RPAP2 and the upper portion of the upper separation structure DB may be removed. The first separation trench ITR1 may vertically overlap the gate electrode GE and expose the gate insulating layer GI surrounding the uppermost inner electrode PO1. The second separation trench ITR2 may vertically overlap the upper separation structure DB and expose the upper surface of the upper separation structure DB.

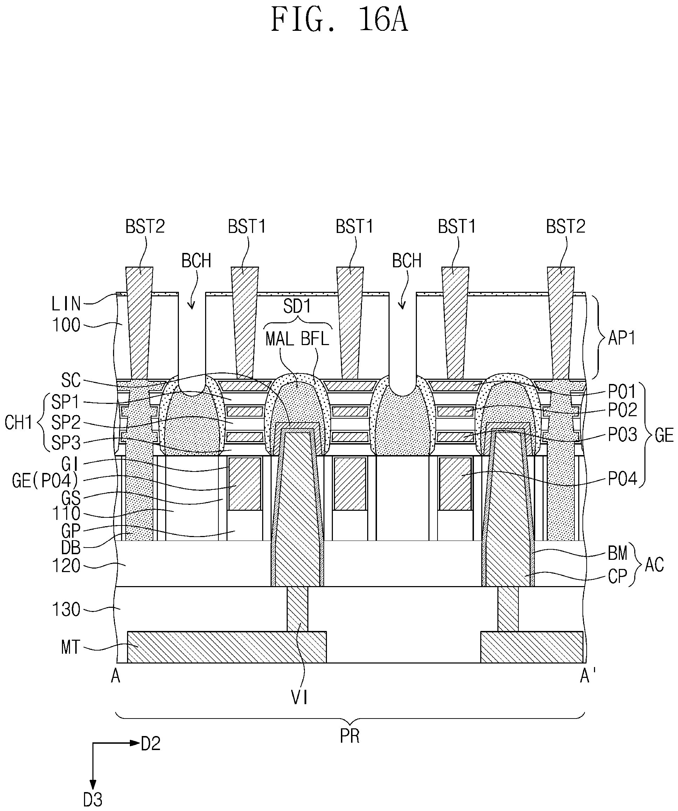

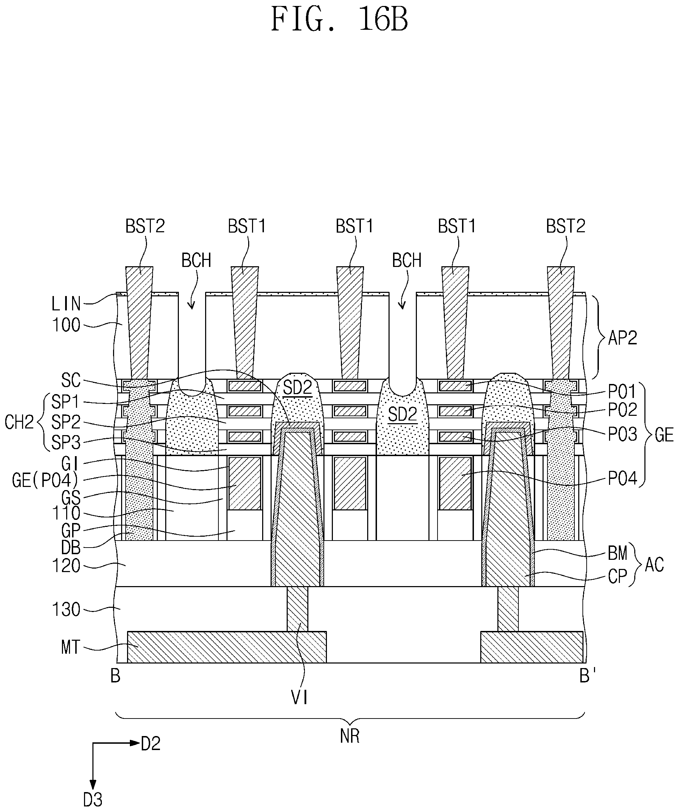

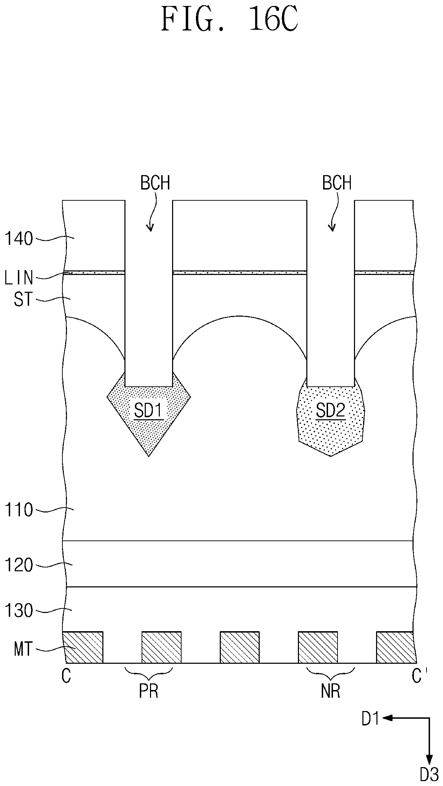

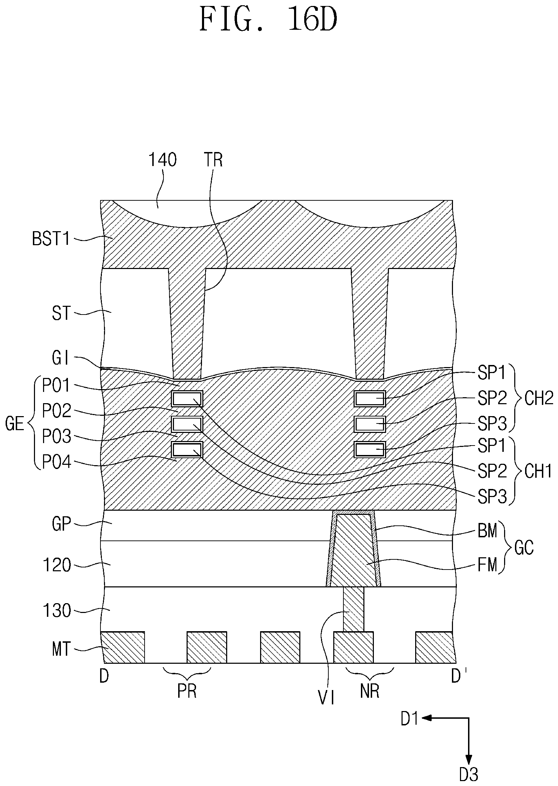

Referring to FIGS. 16A to 16D, first backside separation structures BST1 and second backside separation structures BST2 may be formed. Forming the backside separation structures BST1 and BST2 may include filling the separation trenches ITR1 and ITR2 between the mask patterns MK (e.g., in FIG. 15A), respectively, with an insulating material and removing the mask pattern MK (e.g., in FIG. 15A). The first backside separation structure BST1 may extend in the first direction D1 and fill the trench TR from which the residual active patterns RPAP1 and RPAP2 have been removed. The second backside separation structure BST2 may extend in the first direction D1 and be connected to the upper separation structure DB.

As the mask pattern MK (e.g., in FIG. 15A) is removed after forming the backside separation structures BST1 and BST2, the backside separation structures BST1 and BST2 may protrude upward from the liner layer LIN.

According to one or more embodiments, the upper separation structure DB and the second backside separation structure BST2 may be formed individually and connected to each other, and may have a relatively lower height than when a single separation structure separating the single height cell SHC (e.g., in FIG. 4) is formed. For example, a depth of the trench (or recess) may be reduced in the process of forming the upper separation structure DB and the second backside separation structure BST2. As a result, insulation characteristics of the upper separation structure DB and the second backside separation structure BST2 may be improved. For example, a seam may not be formed in the upper separation structure DB and the second backside separation structure BST2. Therefore, reliability of semiconductor devices may be improved.

Furthermore, the backside separation structures BST1 and BST2 may be formed simultaneously. As the second backside separation structure BST2 may be formed during the process of forming the first backside separation structure BST1, which prevents flow of leakage current in adjacent source/drain patterns, thereby improving productivity of the semiconductor device.

Next, a lower insulating pattern 140 may be formed on the device isolation layer ST. The lower insulating pattern 140 may extend in the second direction D2 and may be formed on regions excluding the PMOSFET region PR and NMOSFET region NR.

Afterwards, an anisotropic etching process may be performed to form backside contact holes BCH exposing the source/drain patterns SD1 and SD2. Through the anisotropic etching process, a portion of the substrate 100, a portion of the device isolation layer ST, and the residual active patterns RPAP1 and RPAP2 may be removed. The backside contact holes BCH may expose the first source/drain pattern SD1 and the second source/drain pattern SD2. Specifically, the backside contact holes BCH may expose source/drain patterns SD1 and SD2 that are not connected to the upper active contact AC.

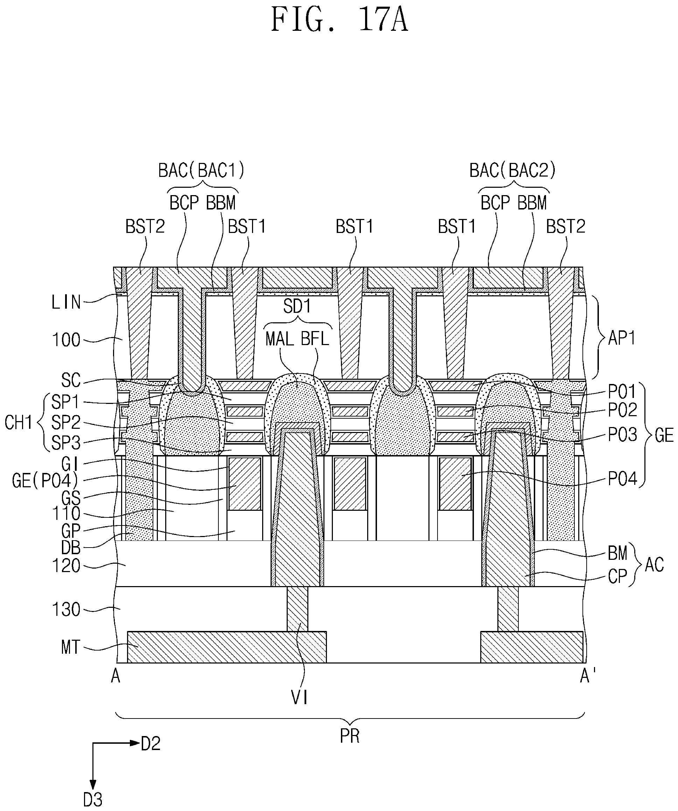

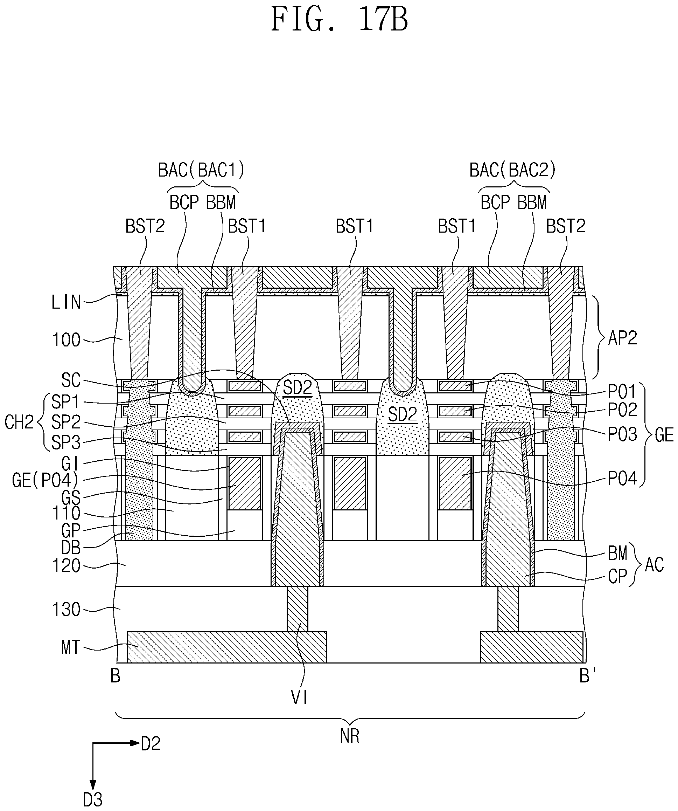

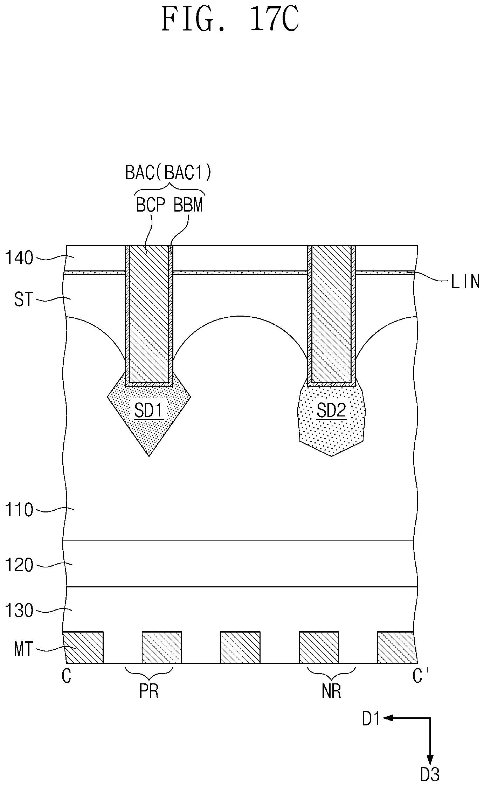

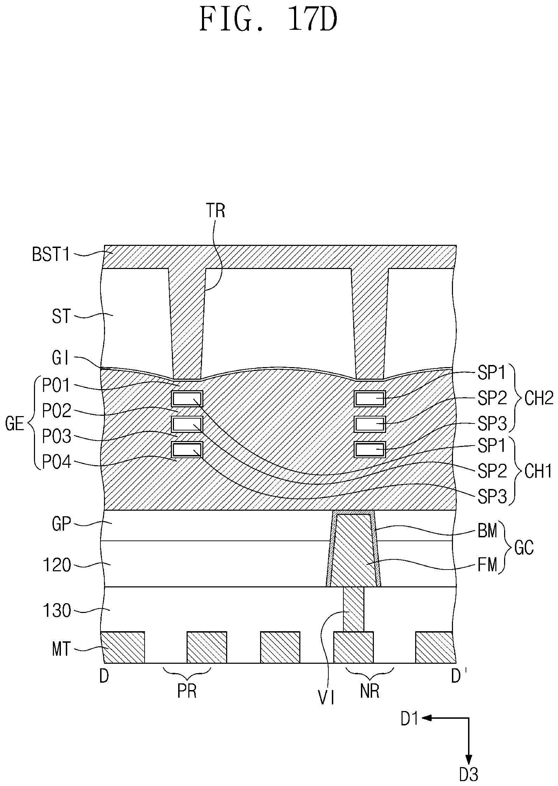

Referring to FIGS. 17A to 17D, backside active contacts BAC may be formed between the first separation structures BST1 and the second backside separation structures BST2. Forming the backside active contacts BAC may include depositing a backside barrier pattern BBM on sidewalls and upper surfaces of the backside separation structures BST1 and BST2 and inner walls of the backside contact holes BCH (e.g., in FIG. 16A), forming a backside conductive pattern BCP to fill a space between the backside separation structures BST1 and BST2 and the backside contact hole BCH (e.g., in FIG. 16A) on the backside barrier pattern BBM, and performing a planarization process to expose upper surfaces of the backside separation structures BST1 and BST2 to separate the backside active contacts BAC1 and BAC2 from each other. For example, the backside barrier pattern BBM may include a metal layer/metal nitride layer, and the backside conductive pattern BCP may include at least one of aluminum, copper, tungsten, molybdenum, and cobalt, not being limited thereto. Through the planarization process, the lower insulating pattern 140, the backside active contact BAC, and upper portions of the backside separation structures BST1 and BST2 may be partially removed. Upper surfaces of the backside active contacts BAC1 and BAC2 and upper surfaces of the backside separation structures BST1 and BST2 may be substantially coplanar with each other.

Again, referring to FIGS. 4 and 5A to 5D, a power transmission network layer PDN including a first lower power line VPR1 and a second lower power line VPR2 may be formed under the backside active contact BAC and the backside separation structures BST1 and BST2.

The semiconductor device according to the above embodiments may include a backside separation structure vertically connected to an upper separation structure after forming the upper separation structure first. Forming the upper separation structure and then forming the backside separation structure connected thereto at the backside may cause the height of each of the upper separation structure and the backside separation structure to be relatively reduced, compared to the case where a single separation structure is formed. Accordingly, when forming the upper separation structure and the backside separation structure, a seam may not be formed inside each of the two separation structures, or the size of the seam may become small. This may improve the reliability of the semiconductor device.

Furthermore, the backside separation structure may be formed simultaneously with another backside separation structure formed vertically below a gate electrode and a channel pattern to prevent the flow of leakage current between source/drain patterns of a transistor through a substrate, thereby improving the productivity of the semiconductor device.

While embodiments are described above, a person skilled in the art may understand that many modifications and variations are made without departing from the scope of the invention defined in the following claims..
Embodiments are set out in the following clauses:
Clause 1. A semiconductor device comprising: a substrate; source/drain patterns on the substrate; a channel pattern between the source/drain patterns, the channel pattern comprising a plurality of semiconductor patterns; a gate electrode between the plurality of semiconductor patterns; an upper separation structure extending in a first direction and spaced apart from the gate electrode in a second direction intersecting the first direction; a first backside separation structure penetrating the substrate below the gate electrode in a third direction intersecting the first direction and the second direction; and a second backside separation structure penetrating the substrate and overlapping the upper separation structure in the third direction.
Clause 2. The semiconductor device of clause 1, wherein bottom surfaces of the first backside separation structure and the second backside separation structure are substantially coplanar.
Clause 3. The semiconductor device of clause 1 or 2, further comprising a backside active contact penetrating the substrate and connected to one of the source/drain patterns,
   wherein a portion of the backside active contact is in contact with sidewalls of the first backside separation structure and the second backside separation structure.
Clause 4. The semiconductor device of clause 3, wherein a bottom surface of the backside active contact is substantially coplanar with bottom surfaces of the first backside separation structure and the second backside separation structure.
Clause 5. The semiconductor device of clause 3 or 4, wherein the backside active contact comprises a backside conductive pattern and a backside barrier pattern on the backside conductive pattern, wherein a portion of the backside barrier pattern is in contact with the sidewalls of the first backside separation structure and the second backside separation structure. Clause 6. The semiconductor device of clause 3, 4 or 5, further comprising a power transmission network layer below the first backside separation structure and the second backside separation structure and the backside active contact, and connected to the backside active contact.
Clause 7. The semiconductor device of any one of clauses 1 to 6, wherein the upper separation structure comprises a first portion extending in the third direction, a second portion protruding from the first portion toward side surfaces of the source/drain patterns in the second direction, and a third portion in the substrate, the third portion connected to the first portion. Clause 8. The semiconductor device of clause 7, wherein the third portion is on a portion of a sidewall of the second backside separation structure.
Clause 9. The semiconductor device of any one of clauses 1 to 8, further comprising a gate insulating layer between the gate electrode and the plurality of semiconductor patterns, wherein the gate electrode comprises a first inner electrode, a second inner electrode, and a third inner electrode respectively between adjacent semiconductor patterns among the plurality of semiconductor patterns, and an outer electrode on the uppermost semiconductor pattern in the third direction, wherein the first backside separation structure is in contact with a bottom surface of the gate insulating layer surrounding the first inner electrode.
Clause 10. The semiconductor device of any one of clauses 1 to 9, wherein each of the first backside separation structure and the second backside separation structure comprises at least one of a silicon oxide layer, a silicon nitride layer, and a silicon oxynitride layer.
Clause 11. A semiconductor device comprising: a substrate; source/drain patterns on the substrate; a channel pattern between the source/drain patterns, the channel pattern comprising a plurality of semiconductor patterns; a gate electrode between the plurality of semiconductor patterns; an upper separation structure spaced apart from the gate electrode; a first backside separation structure penetrating the substrate below the gate electrode; and a second backside separation structure penetrating the substrate and overlapping the upper separation structure, wherein bottom surfaces of the first and second backside separation structures are positioned at a level lower than a bottom surface of the substrate.
12. The semiconductor device of clause 11, wherein the first backside separation structure and the second backside separation structure are spaced apart from each other.
13. The semiconductor device of clause 11 or 12, wherein the bottom surfaces of the first and second backside separation structures are substantially coplanar with each other.
14. The semiconductor device of clause 11, 12 or 13, further comprising a backside active contact penetrating the substrate and connected to one of the source/drain patterns, wherein a portion of the backside active contact is in contact with sidewalls of the first backside separation structure and the second backside separation structure.
15. The semiconductor device of any one of clauses 11 to 14, wherein the upper separation structure comprises a first portion extending vertically, a second portion protruding horizontally from the first portion toward side surfaces of the source/drain patterns, and a third portion in the substrate, the third portion connected to the first portion.

## Claims

1. A semiconductor device comprising:
a substrate;
source/drain patterns on the substrate;
a channel pattern between the source/drain patterns, the channel pattern comprising a plurality of semiconductor patterns;
a gate electrode between the plurality of semiconductor patterns;
an upper separation structure spaced apart from the gate electrode;
a first backside separation structure penetrating the substrate below the gate electrode; and
a second backside separation structure penetrating the substrate and overlapping the upper separation structure.

2. The semiconductor device of claim 1, wherein bottom surfaces of the first backside separation structure and the second backside separation structure are substantially coplanar.

3. The semiconductor device of claim 1 or 2, wherein bottom surfaces of the first and second backside separation structures are positioned at a level lower than a bottom surface of the sub strate

4. The semiconductor device of claim 1, 2 or 3, further comprising a backside active contact penetrating the substrate and connected to one of the source/drain patterns,
wherein a portion of the backside active contact is in contact with sidewalls of the first backside separation structure and the second backside separation structure.

5. The semiconductor device of claim 4, wherein a bottom surface of the backside active contact is substantially coplanar with bottom surfaces of the first backside separation structure and the second backside separation structure.

6. The semiconductor device of claim 4 or 5, wherein the backside active contact comprises a backside conductive pattern and a backside barrier pattern on the backside conductive pattern,
wherein a portion of the backside barrier pattern is in contact with the sidewalls of the first backside separation structure and the second backside separation structure.

7. The semiconductor device of claim 4, 5 or 6, further comprising a power transmission network layer below the first backside separation structure and the second backside separation structure and the backside active contact, and connected to the backside active contact.

8. The semiconductor device of any one of claims 1 to 7, wherein the upper separation structure comprises a first portion extending in the third direction, a second portion protruding from the first portion toward side surfaces of the source/drain patterns in the second direction, and a third portion in the substrate, the third portion connected to the first portion.

9. The semiconductor device of claim 8, wherein the third portion is on a portion of a sidewall of the second backside separation structure.

10. The semiconductor device of any one of claims 1 to 9, further comprising a gate insulating layer between the gate electrode and the plurality of semiconductor patterns,
wherein the gate electrode comprises a first inner electrode, a second inner electrode, and a third inner electrode respectively between adjacent semiconductor patterns among the plurality of semiconductor patterns, and an outer electrode on the uppermost semiconductor pattern in the third direction,
wherein the first backside separation structure is in contact with a bottom surface of the gate insulating layer surrounding the first inner electrode.

11. The semiconductor device of any one of claims 1 to 10, wherein each of the first backside separation structure and the second backside separation structure comprises at least one of a silicon oxide layer, a silicon nitride layer, and a silicon oxynitride layer.

12. The semiconductor device of any one of claims 1 to 11 wherein:
the upper separation structure extends in a first direction and is spaced apart from the gate electrode in a second direction intersecting the first direction;
the first backside separation structure penetrates the substrate below the gate electrode in a third direction intersecting the first direction and the second direction; and
the second backside separation structure penetrates the substrate and overlaps the upper separation structure in the third direction.

13. The semiconductor device of any one of claims 1 to 12, wherein the first backside separation structure and the second backside separation structure are spaced apart from each other.

14. The semiconductor device of any one of claims 1 to 13, wherein the upper separation structure comprises a first portion extending vertically, a second portion protruding horizontally from the first portion toward side surfaces of the source/drain patterns, and a third portion in the substrate, the third portion connected to the first portion.
